# EUROPEAN PATENT SPECIFICATION

(11) **EP 2 775 514 B1**
(45) Date of publication and mention of the grant of the patent: **21.03.2018**
(21) Application number: 13191897.1
(22) Date of filing: 07.11.2013
(51) Int. Cl.: H01L 23/24, H03K 17/95, G01D 11/24

(54) **Resin-sealed electronic device**
Mit Harz versiegelte elektronische Vorrichtung
Dispositif électronique encapsulé avec de la résine

(30) Priority: 08.03.2013 JP 2013046482
(43) Date of publication of application: 10.09.2014
(73) Proprietor: OMRON CORPORATION, Kyoto-shi, Kyoto 600-8530 (JP)
(72) Inventor: Sanda, Takaaki, Kyoto-shi Kyoto 600-8530 (JP); Nishikawa, Kazuyoshi, Kyoto-shi Kyoto 600-8530 (JP); Sugimoto, Makoto, Kyoto-shi Kyoto 600-8530 (JP); Yuri, Takashi, Kyoto-shi Kyoto 600-8530 (JP); Honjo, Takuya, Kyoto-shi Kyoto 600-8530 (JP); Kameda, Takamasa, Kyoto-shi Kyoto 600-8530 (JP); Inoue, Daisuke, Kyoto-shi Kyoto 600-8530 (JP); Hirao, Koichi, Kyoto-shi Kyoto 600-8530 (JP); Kotani, Shinjiro, Kyoto-shi Kyoto 600-8530 (JP); Nakayama, Yusuke, Kyoto-shi Kyoto 600-8530 (JP)
(74) Representative: Horn Kleimann Waitzhofer Patentanwälte PartG mbB

(56) References cited:
- EP-A1- 0 884 565
- US-A1- 2010 064 788
- US-B2- 7 649 349

## Description

### BACKGROUND OF THE INVENTION

### TECHNICAL FIELD

The present invention relates to an electronic device, particularly to an electronic device in which an internal device is sealed using a resin.

### RELATED ART

Japanese Unexamined Patent Application Publication No. 10-511716 discloses a molding product. The molding product is produced from a polyurethane hot-melt adhesive. The polyurethane hot-melt adhesive has a viscosity less than 100 Pa•s in a melting state at processing temperatures of 70 to 190°C.

Japanese Unexamined Patent Publication No. 2002-318240 discloses a moving object detector. The moving object detector includes a stress suppressor that suppresses stress applied on a circuit board caused by a filling material.

Japanese Unexamined Patent Publication No. 09-092105 discloses a proximity sensor producing method. The producing method includes a primary filling process with resin and a secondary filling process with resin.
Patent Document US 7 649 349 B2 discloses an electronic device comprising a case member 14 with a tubular shape and first and second end portions with the second end portion being closed; a flow control member 26,30 that has a tubular shape comprising a first opening at one end and a second opening at the other end, the first opening and the second opening being disposed in the case member such that the first opening is located on a side of the first end portion and such that the second opening is located on a side of the second end portion; and a sealing resin that is formed by solidification of a resin injected through a gate 40 after the resin spreads into the case member by flowing in a first flow path between an inner surface of the case member and an outer surface of the flow control member and a second flow path constructed by a tubular internal space of the flow control member, the gate being provided between the first end portion of the case member and the first opening of the flow control member, wherein the first flow path and the second flow path are in communication with each other on the side of the second end portion.

### SUMMARY

The present invention has been devised to solve the problems described above, and an object thereof is to provide an electronic device that can suppress suction of an air bubble in a post-sealing electronic device or degradation of water-resistant performance due to the residual air bubble in a neighborhood of a fitting portion in which components are fitted in each other.

In accordance with one aspect of the present invention, an electronic device in accordance with claim 1 is provided.

Preferably an area of the second opening is larger than an area of the first opening. Preferably the flow control member is disposed coaxially with a center axis of the inner surface of the case member.

Preferably a cross sectional shape of the outer surface of the flow control member has a circle shape corresponding to a shape of the inner surface of the case member. Preferably the sealing resin includes a thermoplastic resin having a hardness (shore D) of 60 or less.

Preferably the flow control member includes only the first opening and the second opening.

Accordingly, the present invention can provide the electronic device that can suppress the suction of the air bubble in the post-sealing electronic device and/or the degradation in water-resistant performance due to the residual air bubble in the neighborhood of the fitting portion in which the components are fitted in each other.

### BRIEF DESCRIPTION OF THE DRAWINGS

Fig. 1 is a perspective view illustrating a proximity sensor;
Fig. 2 is a perspective view illustrating a state in which the proximity sensor is taken apart;
Fig. 3 is a sectional view taken on a line III-III in Fig. 1;
Fig. 4 is a sectional view taken on a line IV-IV in Fig. 1;
Fig. 5 is an enlarged sectional view illustrating a neighborhood of a detection coil unit included in the proximity sensor;
Fig. 6 is a perspective view schematically illustrating an internal structure of the detection coil unit included in the proximity sensor;
Fig. 7 is a perspective view illustrating a flow control member included in the proximity sensor;
Fig. 8 is a sectional perspective view corresponding to the flow control member in Fig. 7;
Fig. 9 is another perspective view illustrating the flow control member included in the proximity sensor;
Fig. 10 is a sectional perspective view corresponding to the flow control member in Fig. 9;
Fig. 11 is a sectional view taken on a line XI-XI in Fig. 3;
Fig. 12 is a sectional view taken on a line XII-XII in Fig. 3;
Fig. 13 is a sectional view taken on a line XIII-XIII in Fig. 3;
Fig. 14 is a perspective view illustrating a front cover included in the proximity sensor;
Fig. 15 is a view illustrating the front cover when the front cover is viewed from a direction indicated by an arrow XV in Fig. 14;
Fig. 16 is a view illustrating the front cover when the front cover is viewed from a direction indicated by an arrow XVI in Fig. 14;
Fig. 17 is a view illustrating the front cover when the front cover is viewed from a direction indicated by an arrow XVII in Fig. 14;
Fig. 18 is a view illustrating the front cover when the front cover is viewed from a direction indicated by an arrow XVIII in Fig. 14;
Fig. 19 is a perspective view illustrating a front end portion of the proximity sensor;
Fig. 20 is an enlarged sectional view illustrating a range surrounded by an alternate long and two short dashes line XX in Fig. 3;
Fig. 21 is an enlarged sectional view illustrating a range surrounded by an alternate long and two short dashes line XXI in Fig. 4;
Fig. 22 is a view illustrating a first process of a method for producing the proximity sensor of the embodiment;
Fig. 23 is a view illustrating a second process of the method for producing the proximity sensor of the embodiment;
Fig. 24 is a view illustrating a third process of the method for producing the proximity sensor of the embodiment;
Fig. 25 is a view illustrating a fourth process of the method for producing the proximity sensor of the embodiment;
Fig. 26 is a view illustrating a fifth process of the method for producing the proximity sensor of the embodiment;
Fig. 27 is a view illustrating a sixth process of the method for producing the proximity sensor of the embodiment;
Fig. 28 is a sectional view illustrating the proximity sensor that does not include the flow control member;
Fig. 29 is a sectional view illustrating the proximity sensor that includes another flow control member;
Fig. 30 is a sectional view illustrating the proximity sensor according to a first embodiment of the invention;
Fig. 31 is a perspective view illustrating a proximity sensor according to a modification;
Fig. 32 is a perspective view illustrating a state in which the proximity sensor of the modification is taken apart;
Fig. 33 is a sectional view taken on a line XXXIII-XXXIII in Fig. 31;
Fig. 34 is a view illustrating a first process of the method for producing the proximity sensor of the modification;
Fig. 35 is a view illustrating a second process of the method for producing the proximity sensor of the modification;
Fig. 36 is a view illustrating a third process of the method for producing the proximity sensor of the modification;
Fig. 37 is a table illustrating an experimental condition and a result of Experimental example 1 performed in the embodiment;
Fig. 38 is a sectional view illustrating the flow control member that is used in the Experimental example 1 performed in the embodiment;
Fig. 39 is a table illustrating the experimental condition and the result of Experimental example 2 performed in the embodiment;
Fig. 40 is a sectional view illustrating the flow control member that is used in the Experimental example 2 performed in the embodiment;
Fig. 41 is a sectional view (part 1) illustrating a configuration suitable for the proximity sensor of the embodiment;
Fig. 42 is a sectional view (part 2) illustrating the configuration suitable for the proximity sensor of the embodiment;
Fig. 43 is a sectional view illustrating another modification (part 1) of the proximity sensor of the embodiment;
Fig. 44 is a sectional view illustrating another modification (part 2) of the proximity sensor of the embodiment;
Fig. 45 is a sectional view illustrating another modification (part 3) of the proximity sensor of the embodiment;
Fig. 46 is a sectional view illustrating another modification (part 4) of the proximity sensor of the embodiment;
Fig. 47 is a perspective view illustrating another modification (part 5) of the proximity sensor of the embodiment;
Fig. 48 is a sectional view illustrating another modification (part 6) of the proximity sensor of the embodiment;
Fig. 49 is a sectional view illustrating another modification (part 7) of the proximity sensor of the embodiment;
Fig. 50 is a sectional view illustrating another modification (part 8) of the proximity sensor of the embodiment;
Fig. 51 is a perspective view illustrating another modification (part 9) of the proximity sensor of the embodiment;
Fig. 52 is a perspective view illustrating another modification (part 10) of the proximity sensor of the embodiment;
Fig. 53 is a perspective view illustrating another modification (part 11) of the proximity sensor of the embodiment; and
Fig. 54 is a sectional view illustrating another modification (part 12) of the proximity sensor of the embodiment.

### DETAILED DESCRIPTION

Hereinafter, an embodiment and Examples of the present invention will be described with reference to the drawings. In the embodiment and Examples, the present invention is not limited to the number of pieces and the amount unless otherwise noted. In the embodiment and Examples, the identical or equivalent component is designated by the identical numeral, and overlapping description may be omitted.

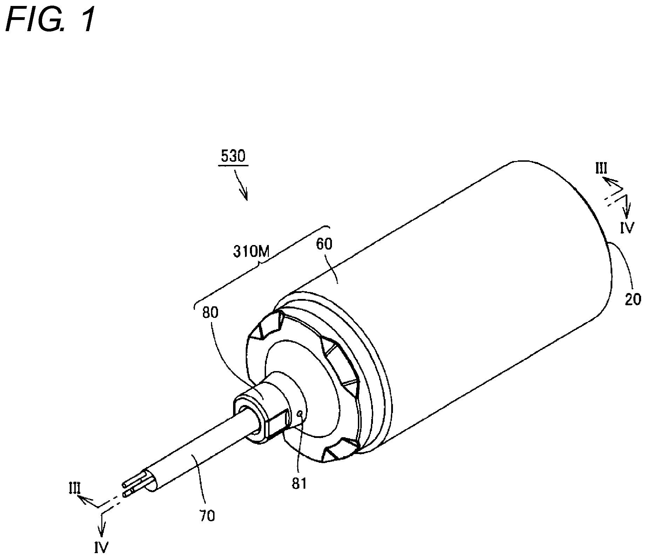

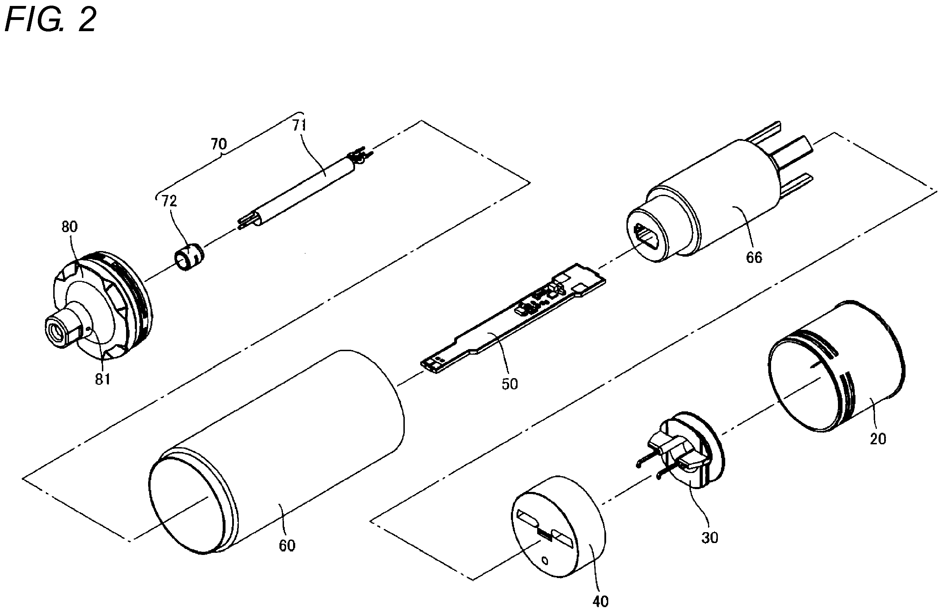

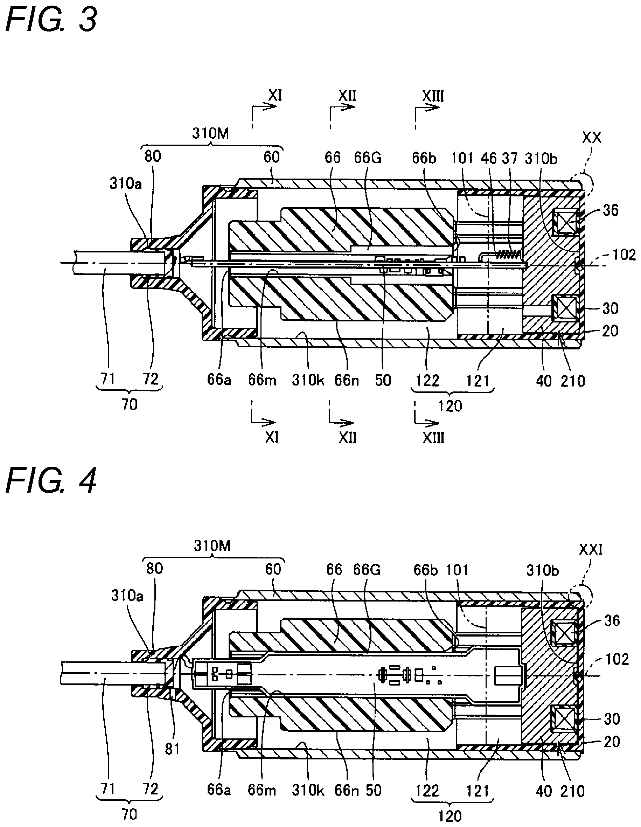

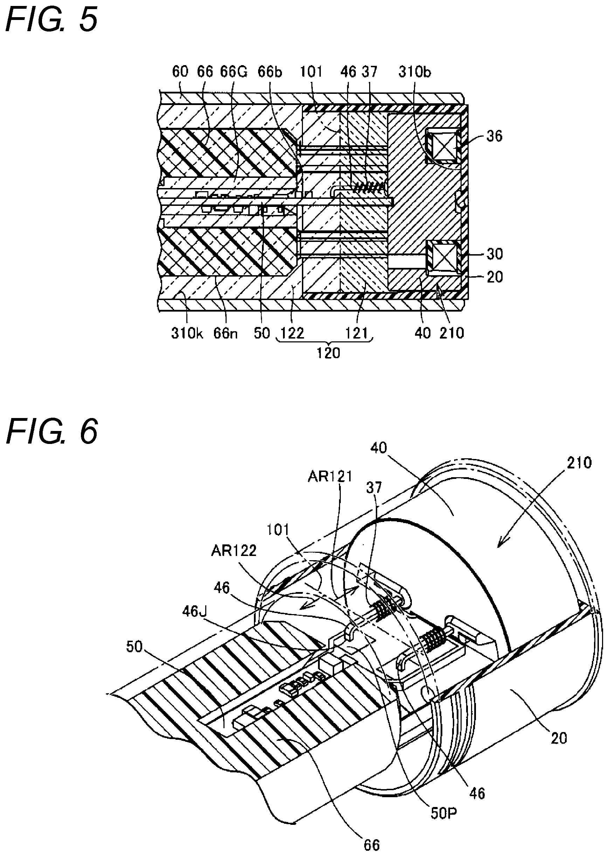

A proximity sensor 530 useful for understanding the invention will be described below with reference to Figs. 1 to 21. Fig. 1 is a perspective view illustrating the proximity sensor 530. Fig. 2 is a perspective view illustrating a state in which the proximity sensor 530 is taken apart. Fig. 3 is a sectional view taken on a line III-III in Fig. 1. Fig. 4 is a sectional view taken on a line IV-IV in Fig. 1. Fig. 5 is an enlarged sectional view illustrating a neighborhood of a detection coil unit 210 included in the proximity sensor 530. Fig. 6 is a perspective view schematically illustrating an internal structure of the detection coil unit 210 included in the proximity sensor 530.

Referring to Figs. 1 to 6, the proximity sensor 530 is an induction-type proximity sensor that detects the approach or presence of a detection target by generating a magnetic field in a detection region. A conductive object is the detection target detected by the proximity sensor 530. Typically magnetic metals such as iron are the detection target detected by the proximity sensor 530, and nonmagnetic metals such as copper and aluminum may be the detection target.

The proximity sensor 530 has a columnar appearance that extends along a virtual center axis 102 (see Figs. 3 and 4). The proximity sensor 530 includes a detection coil unit 210 (see Figs. 3 to 6), a front cover 20 (a coil case), a printed board 50 (see Figs. 3 to 6), a base metallic part 60, a flow control member 66, a clamp 80, and a ring cord 70.

The detection coil unit 210 is provided as a detection unit that detects the approach or presence of the detection target. The detection coil unit 210 generates the magnetic field. The detection coil unit 210 is provided on a front end side of the proximity sensor 530 opposed to the detection region. The detection coil unit 210 is constructed by a combination of a core body 40, an electromagnetic coil 36 (see Figs. 3 to 5), a coil spool 30 (see Figs. 2 to 5), and a coil pin 46 (see Figs. 3 to 6).

The core body 40 is made of a material such as ferrite which has a high frequency property. The core body 40 has a function of enhancing a coil property of the detection coil unit 210 and of concentrating a magnetic flux on the detection region. The electromagnetic coil 36 is a coil wire, and is wound around the coil spool 30. The electromagnetic coil 36 is wound about a center axis 102. The center axis 102 also acts as a winding center axis for the electromagnetic coil 36.

The coil spool 30 (a spool body) is made of a resin having an electrical insulating property. The coil spool 30 is accommodated in a ring-like groove formed in the core body 40. The coil pin 46 is made of conductive metal. The coil pin 46 is supported by the coil spool 30. The coil pin 46 has a shape that extends from the detection coil unit 210 toward the side of the printed board 50. Using solder (not illustrated), an extending end of the coil pin 46 is connected to a pattern 50P (see Fig. 6) formed on the printed board 50.

A leading end 37 of the electromagnetic coil 36 drawn from the outer circumference of the coil spool 30 is wound around a root portion of the coil pin 46 extending from the detection coil unit 210. The electromagnetic coil 36 and the printed board 50 are electrically connected to each other through the coil pin 46 and the solder (not illustrated).

The detection coil unit 210 is accommodated in the front cover 20 (the coil case). The front cover 20 is made of resin. The front cover 20 is made of a thermoplastic resin. For example, the front cover 20 is made of a material such as PBT (polybutylene terephthalate) which exerts a good adhesion property with respect to the thermoplastic resin forming a thermoplastic resin portion 122. The front cover 20 is provided as a front end cover in which the detection coil unit 210 is accommodated. The front cover 20 closes a front end of the base metallic part 60 having a cylindrical shape. The front cover 20 is provided mainly in order to shut off and protect the detection coil unit 210 from an external atmosphere.

The front cover 20 has the cylindrical shape with a bottom. The front cover 20 extends cylindrically with the center axis 102 as the center, and one end of the front cover 20 is closed while the other end is opened. An end surface on the closed end side of the front cover 20 constitutes a detection surface of the proximity sensor 530.

The printed board 50 has an elongated planar shape. The printed board 50 extends with the center axis 102 as a longitudinal direction. Various electronic components (not illustrated) such as a transistor, a diode, a resistor, and a capacitor are mounted on the printed board 50. The electronic components also include one that is electrically connected to the detection coil unit 210. A light emitting diode (LED) (not illustrated) is mounted on the printed board 50. The light emitting diodes are provided in the surface and a back side of the printed board 50 to act as a light emitting unit that indicates a detection state.

The base metallic part 60 is provided as a body case in which the electronic components such as the transistor, the diode, the resistor, and the capacitor are accommodated. The base metallic part 60 constitutes an outline of the proximity sensor 530 on the outer circumference of the center axis 102. The base metallic part 60 has the cylindrical shape that extends with the center axis 102 as the center. The base metallic part 60 extending along the center axis 102 is opened at both ends. The front cover 20 is inserted in one of the opened ends of the base metallic part 60, whereby the front cover 20 is fixed to the base metallic part 60. For example, the base metallic part 60 has an inner diameter of at least 5 mm.

The base metallic part 60 is made of metal. A thread to be used to fix the proximity sensor 530 to an external facility is formed on the outer circumferential surface of the base metallic part 60. The proximity sensor 530 is what is called a sealed type proximity sensor in which the base metallic part 60 is disposed on the outer circumference of the detection coil unit 210. The proximity sensor 530 may be applied to what is called a non-sealed type proximity sensor in which the base metallic part 60 is disposed at a position deviated in the axial direction of the center axis 102 from the outer circumference of the detection coil unit 210.

The clamp 80 is provided as a connection member that is connected to the base metallic part 60 from the rear end side of the proximity sensor 530. The clamp 80 is connected to the rear end of the base metallic part 60 having the cylindrical shape. The clamp 80 is inserted in the rear end of the base metallic part 60. The clamp 80 extends cylindrically with the center axis 102 as the center while being integral with the base metallic part 60. The base metallic part 60 and the clamp 80 constitute a cylindrical case 310M that extends cylindrically with the center axis 102 as the center. The printed board 50 and the electronic components mounted on the printed board 50 are accommodated in the cylindrical case 310M.

The light emitting diode mounted on the printed board 50 is positioned in the clamp 80. The clamp 80 is made of resin. The clamp 80 is made of a transparent or translucent resin such that the emission of the light emitting diode can visually be recognized from the outside of the proximity sensor 530. For example, the clamp 80 is made of polyamide. A gate 81 is formed in the clamp 80. The gate 81 is provided as a through-hole through which the resin is injected into the cylindrical case 310M in producing the proximity sensor 530.

The ring cord 70 is electrically connected to the printed board 50 in the cylindrical case 310M. The ring cord 70 is drawn from the rear end side of the cylindrical case 310M. The ring cord 70 is provided as a rear cover that closes the rear end of the cylindrical case 310M.

The ring cord 70 includes a cable 71 and a ring member 72. The ring member 72 is provided so as to cover the end portion of the cable 71 in the cylindrical case 310M. The ring member 72 ensures a joining property between the cable 71 and a sealing resin 120 provided in the cylindrical case 310M. For example, the ring member 72 is made of PBT (polybutylene terephthalate). For example, the cable 71 is coated with polyvinyl chloride.

In the cylindrical case 310M, the sealing resin 120 is formed by the injection of the resin. In the proximity sensor 530, a tubular case member in which the detection coil unit 210 and the printed board 50 are accommodated is constructed by the cylindrical case 310M, the ring cord 70, and the front cover 20. An inner surface 310k of the case member includes the inner surface of the base metallic part 60, the inner surface of the clamp 80, and the inner surface of the front cover 20. A first end portion 310a is formed in the inner surface 310k on the side of the clamp 80, and a second end portion 310b is formed in the inner surface 310k on the side of the front cover 20.

In the inner surface of the clamp 80, the first end portion 310a is located at a circumferential edge of the opening in which the cable 71 is press-fitted. In the inner surface of the front cover 20, the second end portion 310b is located in the front in the insertion direction of the core body 40. The second end portion 310b that is of the case member is closed by the front cover 20. The inner surface 310k of the case member in which the detection coil unit 210 and the printed board 50 are accommodated has the shape extending from the first end portion 310a toward the second end portion 310b (or the shape extending from the second end portion 310b toward the first end portion 310a).

The sealing resin 120 is provided such that a space of the case member surrounded by the cylindrical case 310M and the front cover 20 and the ring cord 70, which close the front and rear ends of the cylindrical case 310M, is filled with the sealing resin 120. The sealing resin 120 seals the detection coil unit 210 accommodated in the front cover 20 and the printed board 50 and electronic components which are accommodated in the cylindrical case 310M.

### (Sealing resin 120)

The sealing resin 120 includes a thermosetting resin portion 121 and a thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion except the thermosetting resin portion 121 in the case member (the cylindrical case 310, the ring cord 70, and the front cover 20) to seal the printed board 50 and the electronic components. Although described in detail later, the thermoplastic resin having a hardness (shore D) of 60 or less is selected to form the thermoplastic resin portion 122. Although described in detail later, the thermoplastic resin portion 122 is formed by solidification of the thermoplastic resin injected through the gate 81 after the thermoplastic resin flows in a flow path (hereinafter also referred to as a first flow path or an external flow path) formed between the inner surface 310k of the case member and an outer surface 66n of an flow control member 66 and spreads in an internal flow path 66G (hereinafter also referred to as a second flow path) constructed by a tubular internal space of the flow control member 66.

The thermosetting resin portion 121 and the thermoplastic resin portion 122 are provided so as to have a boundary in the front cover 20 indicated by an alternate long and two short dashes line 101 in Figs. 3 to 6. Referring to Fig. 6, the thermosetting resin portion 121 is formed on the side of the direction indicated by an arrow AR121 when viewed from the alternate long and two short dashes line 101, and the thermoplastic resin portion 122 is formed on the side of the direction indicated by an arrow AR122 when viewed from the alternate long and two short dashes line 101.

The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion (on the side of a leading end 46J) extending from the front of the portion around which the leading end 37 of the electromagnetic coil 36 (the coil wire) is wound is sealed by the thermoplastic resin portion 122 (see Fig. 5). In the coil pin 46, the portion soldered to the pattern 50P of the printed board 50 is sealed by the thermoplastic resin portion 122. Alternatively, in the coil pin 46, the portion (on the side of the leading end 46J) extending from the front of the portion around which the leading end 37 of the electromagnetic coil 36 (the coil wire) is wound may be sealed by the thermosetting resin portion 121. In this case, in the coil pin 46, the portion soldered to the pattern 50P of the printed board 50 is sealed by the thermosetting resin portion 121.

The thermoplastic resin that can be molded at low temperature and low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having the hardness (shore D) of 60 or less can reduce stress applied to the internal device due to heat and pressure during the filling of the resin, eliminate necessity for reaction curing, and shorten a process tact time.

A molding machine in which a resin filling pressure is arbitrarily adjusted in a range of 0.1 MPa to 10 MPa may be used as one that fills the thermoplastic resin portion 122 with the thermoplastic resin. The resin filling pressure may be set in the range of at least 0.1 MPa, more preferably the range of at least 1 MPa from the viewpoint of a resin filling property in the detailed structure of the proximity sensor 530. The resin filling pressure may be set in the range of 10 MPa or less, more preferably the range of at least 6 MPa or less from the viewpoint of suppressing damage to the internal component.

An epoxy resin can be cited as a typical example of the thermosetting resin used to form the thermosetting resin portion 121. Preferably the thermosetting resin portion 121 has a small fluctuation in resin stress (stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121.

The sealing resin 120 is not limited to the two-stage segmentation structure including the thermosetting resin portion 121 and the thermoplastic resin portion 122, but the sealing resin 120 may have a segmentation structure of at least three stages. In the case that the sealing resin 120 has the segmentation structure, the resin constituting each layer may be a combination of the identical kind of resin of one of the thermoplastic resin and the thermosetting resin. The sealing resin 120 is not limited to the segmentation structure, but the sealing resin 120 may have a structure in which the detection coil unit 210, the printed board 50, and the electronic components are collectively sealed by one of the thermoplastic resin and the thermosetting resin.

The viscosity of the thermoplastic resin portion 122 ranges preferably from 500 mPa•s to 10000 mPa•s when being measured using a rheometer AR2000EX (a product of TA Instruments Japan Inc.) at a shearing speed of 10 (1/s) and a temperature of 190°C. The viscosity of the thermoplastic resin portion 122 ranges more preferably from 500 mPa•s to 8000 mPa•s when being measured using the rheometer AR2000EX (a product of TA Instruments Japan Inc.) at a shearing speed of 10 (1/s) and a temperature of 190°C.

### (Flow control member 66)

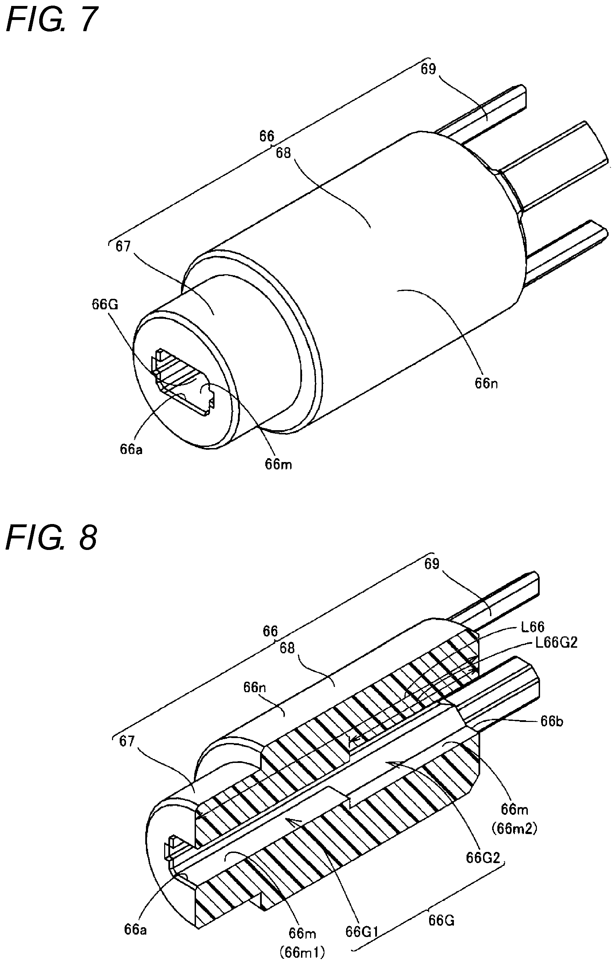

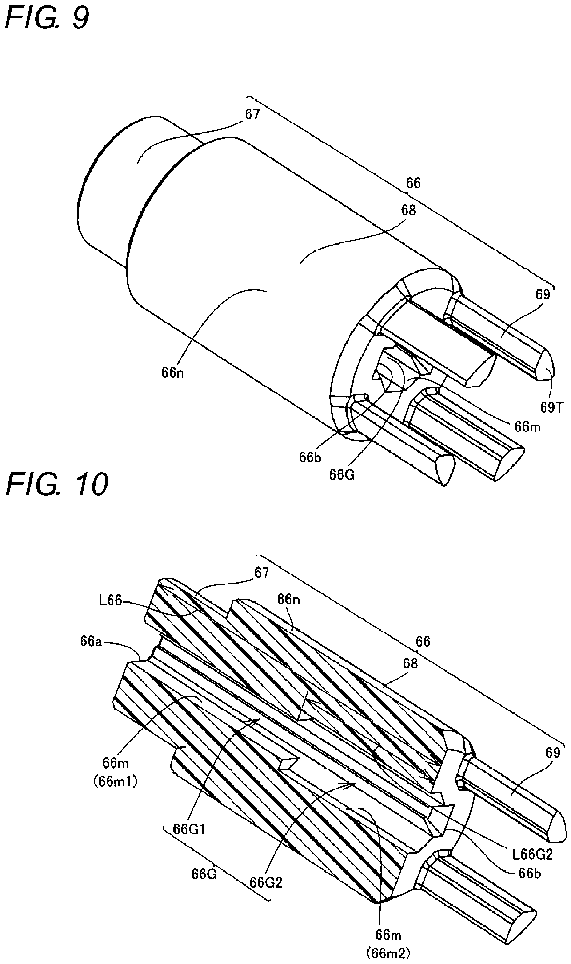

The flow control member 66 disposed inside the base metallic part 60 (see Figs. 3 to 5) will be described in detail with reference to Figs. 7 to 10. Fig. 7 is a perspective view illustrating the flow control member 66. Fig. 8 is a sectional perspective view corresponding to the flow control member 66 in Fig. 7. Fig. 9 is another perspective view illustrating the flow control member 66. Fig. 10 is a sectional perspective view corresponding to the flow control member 66 in Fig. 9.

The flow control member 66 includes a small diameter portion 67, a large diameter portion 68, and four pillar portions 69. The small diameter portion 67 and the large diameter portion 68 have tubular shapes, and are coaxially formed. When an outer surface 66n of the small diameter portion 67 and the large diameter portion 68 are viewed from the axial direction, the outer surface 66n of the cross sectional shape has a circle shape in section. An outer diameter of the small diameter portion 67 is smaller than that of the large diameter portion 68. The small diameter portion 67 is shorter than the large diameter portion 68 in the axial direction.

A first opening 66a is formed in the end portion of the small diameter portion 67, and a second opening 66b is formed in the end portion of the large diameter portion 68. The flow control member 66 has no opening except the first opening 66a and the second opening 66b. The flow control member 66 has a tubular shape extending from the first opening 66a toward the second opening 66b. The flow control member 66 is disposed in the case member such that the first opening 66a is disposed on the side of the first end portion 310a (see Fig. 3), and such that the second opening 66b is disposed on the side of the second end portion 310b (see Fig. 3). The flow control member 66 is disposed coaxially with the center axis 102 of the inner surface 310k of the case member.

An internal flow path 66G (the second flow path) is provided radially inside of the small diameter portion 67 and the large diameter portion 68. The internal flow path 66G is the internal space of the flow control member 66, which is surrounded by an inner surface 66m of the small diameter portion 67 and the large diameter portion 68. The printed board 50 (see Fig. 3) is disposed in the internal flow path 66G. The internal flow path 66G includes a first internal flow path 66G1 having a substantially rectangular solid shape and a second internal flow path 66G2 having a substantially rectangular solid shape. The first internal flow path 66G1 communicates the first opening 66a and second internal flow path 66G2 with each other. The second internal flow path 66G2 communicates the first internal flow path 66G1 and the second opening 66b with each other.

In the first internal flow path 66G1, the first opening 66a is formed on the opposite side to the side continued to the second internal flow path 66G2. In the second internal flow path 66G2, the second opening 66b is formed in the end portion on the opposite side to the side continued to the first internal flow path 66G1. The second opening 66b is continued to the first internal flow path 66G1, and has a flow path cross-section area larger than that of the first internal flow path 66G1. The second opening 66b is formed such that an opening area of the second opening 66b is larger than that of the first opening 66a. An inner surface 66m1 of the inner surface 66m is formed in the first internal flow path 66G1, and an inner surface 66m2 of the inner surface 66m is formed in the second internal flow path 66G2. In the state in which the proximity sensor 530 is assembled, the gate 81 provided in the clamp 80 is located between the first end portion 310a and the first opening 66a of the flow control member 66 in the direction of the center axis 102.

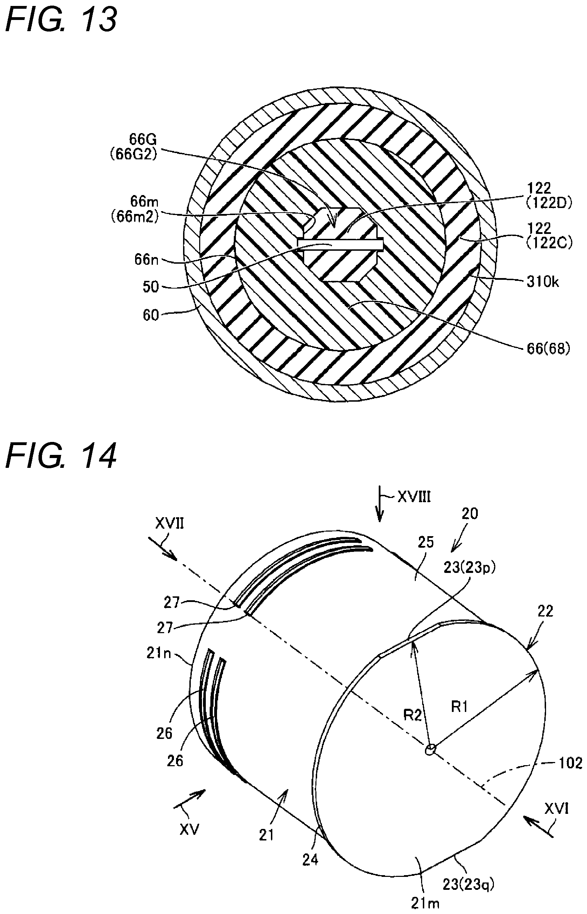

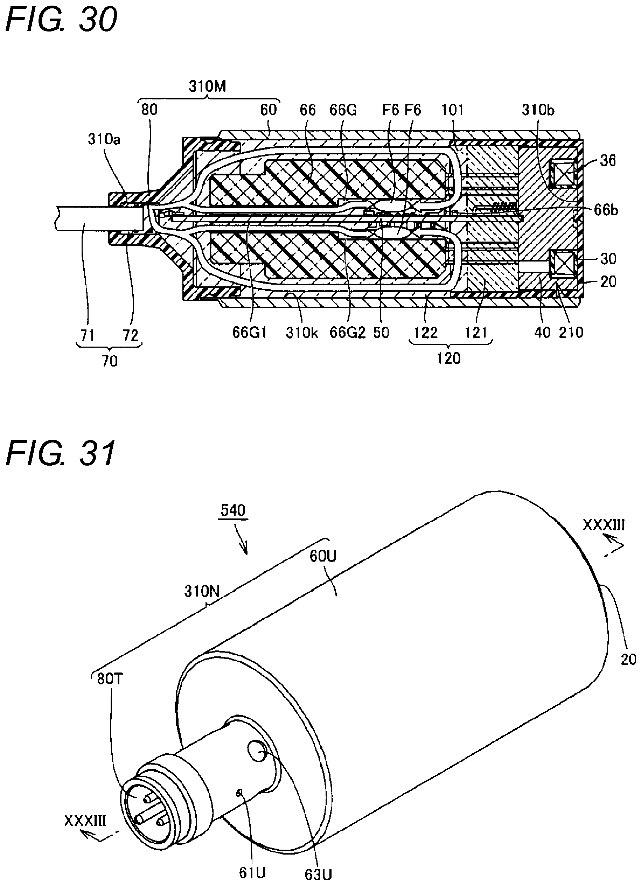

In the embodiment, the second internal flow path 66G2 is a region satisfying a relationship of C : D = 1 to 7 : 1 (described in detail later with reference to Figs. 13 and 30), and the second internal flow path 66G2 extends toward the side of the first opening 66a with the second opening 66b as a starting point. In the extending direction of the flow control member 66 (in the embodiment, extending direction of the center axis 102), a length L66G2 of the second internal flow path 66G2 ranges from 10% to 70% with respect to a length L66 between the first opening 66a and the second opening 66b.

The four pillar portions 69 are provided on the opposite side to the small diameter portion 67 when viewed from the large diameter portion 68. The four pillar portions 69 are disposed at intervals of 90° around the second opening 66b, and extend in parallel with the axial directions of the small diameter portion 67 and the large diameter portion 68. In the state in which the flow control member 66 is disposed inside the base metallic part 60 (see Fig. 3), an end portion 69T (see Fig. 9) of the pillar portion 69 comes close to or abuts on the end surface of the core body 40 (see Fig. 3).

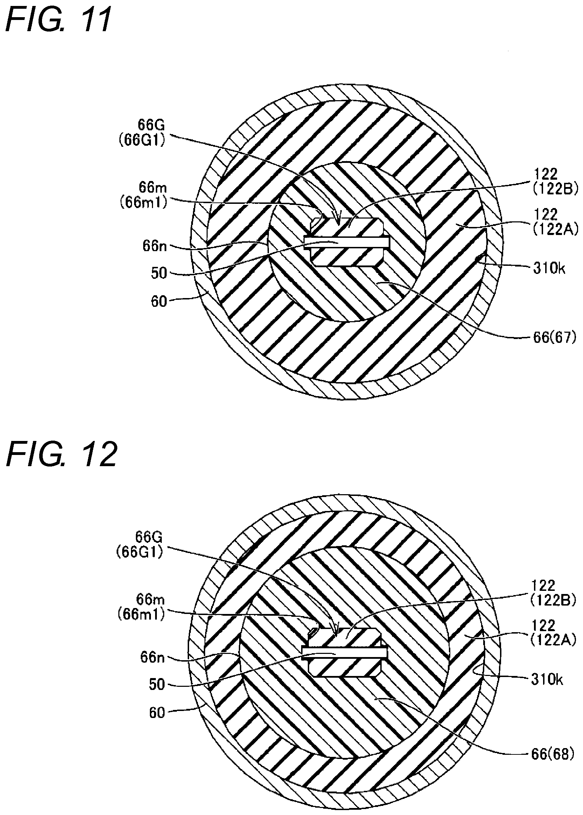

Fig. 11 is a sectional view taken on a line XI-XI in Fig. 3. Fig. 11 is the sectional view corresponding to the small diameter portion 67 (see Fig. 7) in the flow control member 66. Fig. 12 is a sectional view taken on a line XII-XII in Fig. 3. Fig. 12 is the sectional view corresponding to the large diameter portion 68 (see Fig. 7) and the first internal flow path 66G1 in the flow control member 66. Fig. 13 is a sectional view taken on a line XIII-XIII in Fig. 3. Fig. 13 is the sectional view corresponding to the large diameter portion 68 (see Fig. 7) and the second internal flow path 66G2 in the flow control member 66.

Referring to Figs. 11 to 13, as described above, the sealing resin 120 is provided such that the space in the case member surrounded by the cylindrical case 310M and the front cover 20 and the ring cord 70, which close the front and rear ends of the cylindrical case 310M, is filled with the sealing resin 120. In forming the thermoplastic resin portion 122 of the sealing resin 120 in the case member, the case member is filled with the thermoplastic resin through the gate 81 provided in the case member.

The thermoplastic resin portion 122 of the sealing resin 120 is formed by the solidification of the thermoplastic resin injected through the gate 81 after the thermoplastic resin spreads in the external flow path or the first flow path between the inner surface 310k of the case member (the base metallic part 60) and the outer surface 66n of the flow control member 66 and spreads in the internal flow path 66G or the second flow path inside the flow control member 66 through the first opening 66a and the second opening 66b.

The cross sectional shape orthogonal to the extending direction (in the embodiment, the extending direction of the center axis 102) of the flow control member 66 is referred to as a first cross sectional shape. In the embodiment, one of or all the shapes illustrated in Figs. 11 to 13 are obtained as the first cross sectional shape. In the first cross sectional shape, it is assumed that A is an area of the sealing resin 120 (a thermoplastic resin portion 122A) formed in the first flow path or the external flow path between the inner surface 310k of the case member (the base metallic part 60) and the outer surface 66n of the flow control member 66. In the first cross sectional shape, it is assumed that B is an area of the sealing resin 120 (a thermoplastic resin portion 122B) formed in the internal flow path 66G inside the flow control member 66.

In the embodiment, the cross sectional shapes of the external flow path (the first flow path) and the internal flow path 66G (the second flow path) are formed such that the resin flowing in and filling the external flow path through the gate 81 reaches the second opening 66b earlier than the resin flowing in and filling the internal flow path 66G through the gate 81. For example, the configuration can be implemented as follows.

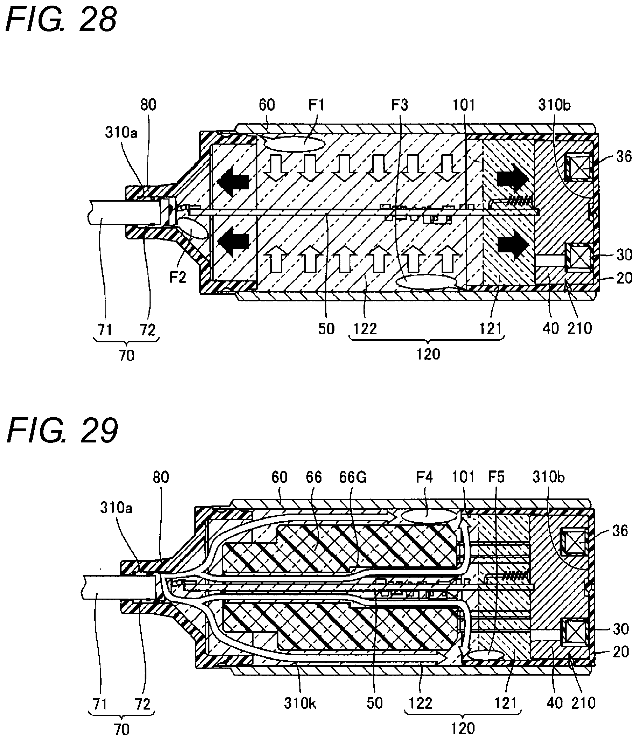

In the embodiment, the sealing resin 120 (the thermoplastic resin portion 122A) formed between the inner surface 310k of the case member (the base metallic part 60) and the outer surface 66n of the flow control member 66 has the thickness of 2 mm to 4 mm, and a relationship of A: B = 3 to 37 : 1 holds for the first cross sectional shape of one of or all the positions in the extending direction of the flow control member 66. In other words, the sealing resin 120 (the thermoplastic resin portion 122A) formed between the inner surface 310k of the case member (the base metallic part 60) and the outer surface 66n of the flow control member 66 has the thickness of 2 mm to 4 mm, and the thermoplastic resin portion 122A formed outside the flow control member 66 has the area (an area ratio) of 3 to 37 when the thermoplastic resin portion 122B formed in the internal flow path 66G of the flow control member 66 has the area of 1. The detailed action and effect of the configuration are described later with reference to Figs. 28 to 30.

### (Front cover 20 and base metallic part 60)

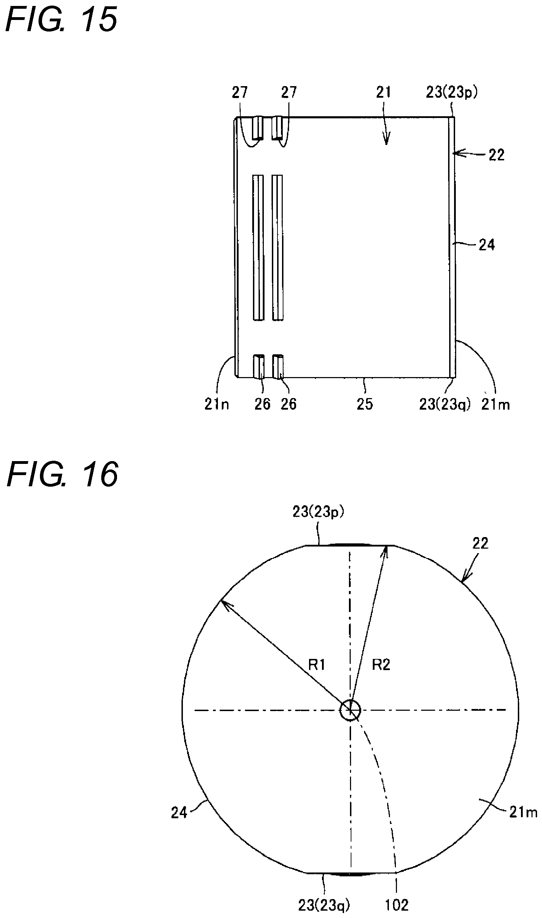

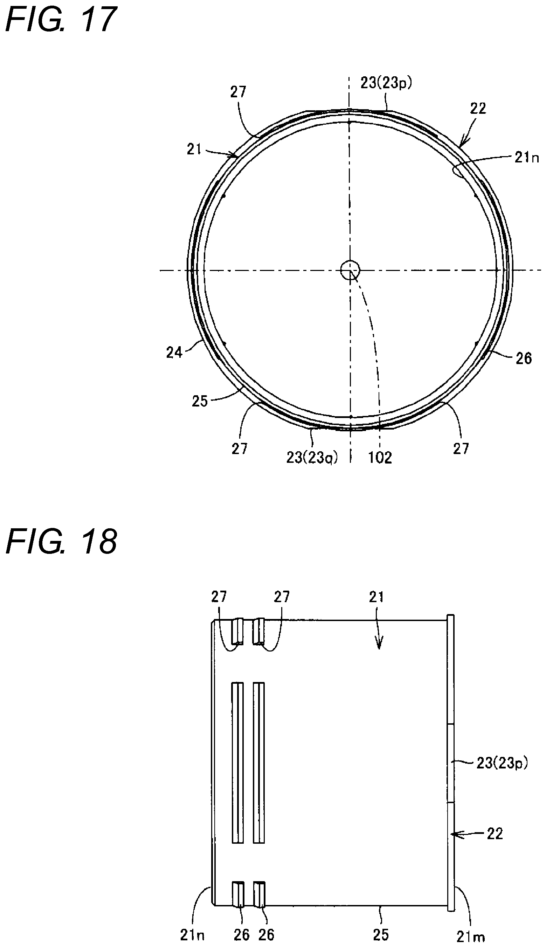

Fig. 14 is a perspective view illustrating the front cover 20. Fig. 15 is a view illustrating the front cover when the front cover 20 is viewed from a direction indicated by an arrow XV in Fig. 14. Fig. 16 is a view illustrating the front cover 20 when the front cover 20 is viewed from a direction indicated by an arrow XVI in Fig. 14. Fig. 17 is a view illustrating the front cover 20 when the front cover 20 is viewed from a direction indicated by an arrow XVII in Fig. 14. Fig. 18 is a view illustrating the front cover 20 when the front cover 20 is viewed from a direction indicated by an arrow XVIII in Fig. 14. In the drawings, the center axis 102 is indicated when the front cover 20 is assembled in the proximity sensor 530.

Referring to Figs. 14 to 18, the front cover 20 includes a cylindrical portion 21, a rib-shape portion 26, and a guard portion 22 as structural components. The cylindrical portion 21 includes a closed end 21m in one of the end portions of the cylindrical portion 21 and an opened end 21n in the other end portion of the cylindrical portion 21. A space in which the detection coil unit 210 is accommodated is formed in the cylindrical portion 21. The cylindrical portion 21 includes an outer circumferential surface 25.

The rib-shape portion 26 is projected from the outer circumferential surface 25 of the cylindrical portion 21. An air vent 27 is formed in the rib-shape portion 26. The guard portion 22 is provided on the side of the closed end 21m of the cylindrical portion 21. The guard portion 22 has a circular shape with the center axis 102 as the center, and a diameter of the guard portion 22 is larger than that of the outer circumferential surface 25 of the cylindrical portion 21. The guard portion 22 includes an outer circumferential edge 24.

A notch 23 is formed in the guard portion 22. The notch 23 is formed such that a length from the center axis 102 to the outer circumferential edge 24 of the guard portion 22 is not uniform around the center axis 102. As illustrated in Figs. 14 and 16, the guard portion 22 has a length R1 from the center axis 102 to the outer circumferential edge 24 of the guard portion 22 at the position where the notch 23 is not formed, and has a length R2 from the center axis 102 to the outer circumferential edge 24 of the guard portion 22 at the position where the notch 23 is formed. The length R2 is a variable value smaller than the length R1 (R2 < R1).

The notch 23 is provided such that the outer circumferential edge 24 of the guard portion 22 is liner when viewed in the direction of the center axis 102. The notch 23 is provided such that the outer circumferential edge 24 of the guard portion 22 is a tangent to the outer circumferential surface 25 of the cylindrical portion 21 when viewed in the direction of the center axis 102. The notch 23 includes a notch 23p and a notch 23q. The notch 23p and the notch 23q are provided 180 degrees apart in the circle having the center axis 102 as the center.

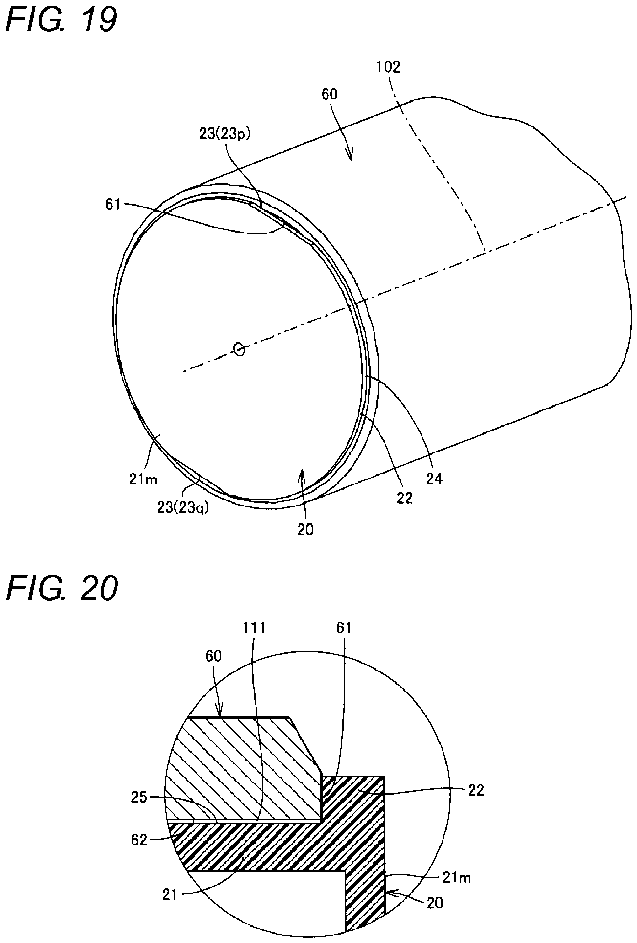

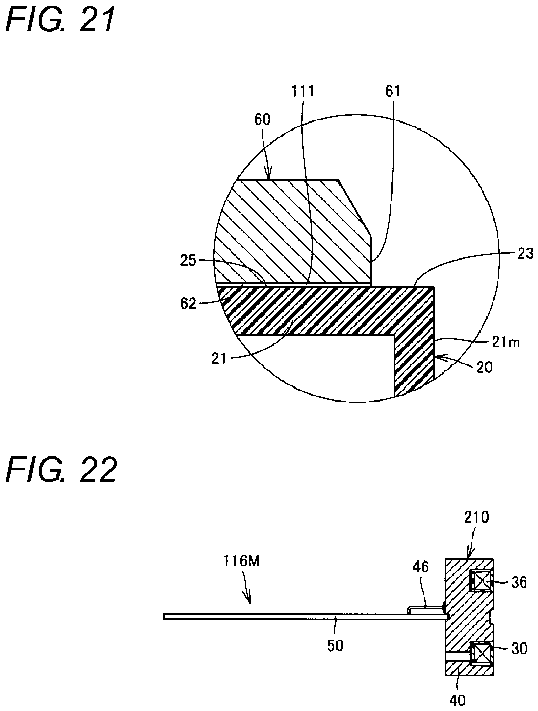

Fig. 19 is a perspective view illustrating the front end portion of the proximity sensor 530 (see Fig. 1). Fig. 20 is an enlarged sectional view illustrating a range surrounded by an alternate long and two short dashes line XX in Fig. 3. Fig. 21 is an enlarged sectional view illustrating a range surrounded by an alternate long and two short dashes line XXI in Fig. 4.

Referring to Figs. 3, 4, and 19 to 21, the base metallic part 60 is fitted on the outer circumference of the cylindrical portion 21 from the side of the end 21n (see Fig. 14), and assembled in the front cover 20 while abutting on the guard portion 22. The base metallic part 60 includes a front surface 61 disposed on the front end side of the proximity sensor 530. The guard portion 22 of the front cover 20 and the front surface 61 of the base metallic part 60 are in contact with each other. The base metallic part 60 abuts on the guard portion 22 to regulate the movement of the front cover 20 onto the rear end side of the proximity sensor 530.

In the base metallic part 60, the rib-shape portion 26 is compressively deformed by the base metallic part 60. The front cover 20 is fixed to the base metallic part 60 by press-fitting. A gap 111 is formed between the outer circumferential surface 25 of the front cover 20 and the base metallic part 60. The gap 111 is set to a minute size enough for the resin, with which the cylindrical case 310M is filled, not to invade into the gap 111 during the production of the proximity sensor 530. For example, the gap 111 has the size of 0.3 mm or less.

Fig. 21 illustrates the section at the position where the notch 23 is provided in the guard portion 22. The notch 23 is provided to expose the gap 111 between the outer circumferential surface 25 of the front cover 20 and the base metallic part 60. The base metallic part 60 abuts on the guard portion 22, whereby the gap 111 is closed by the guard portion 22 while the gap 111 is in communication with the external space at the position where the notch 23 is provided.

### (Producing method)

A method for producing the proximity sensor 530 (see Fig. 1) will be described with reference to Figs. 22 to 27. Referring to Fig. 22, a sub-assembly 116M including the detection coil unit 210 and the printed board 50 is assembled. Specifically, the printed board 50 is connected to the core body 40 while the core body 40 and the coil spool 30, around which the electromagnetic coil 36 is wound, is combined. The leading end of the coil pin 46 is soldered to the surface (the pattern 50P in Fig. 6) of the printed board 50 to electrically connect the electromagnetic coil 36 and the printed board 50.

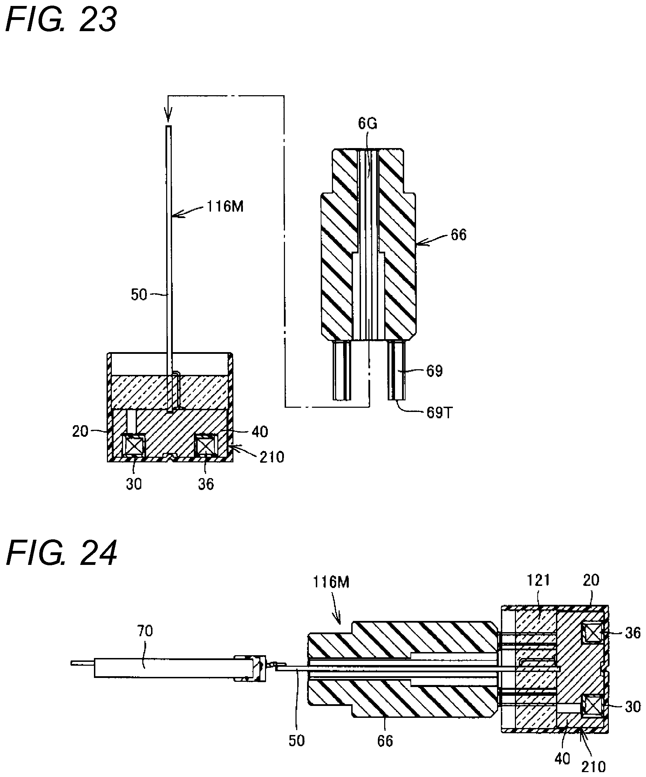

Referring to Fig. 23, the front cover 20 and the flow control member 66 are assembled in the sub-assembly 116M. Specifically, the front cover 20 is filled with the thermosetting resin as a primary injection resin. The sub-assembly 116M is inserted and disposed in the front cover 20 from the side of the detection coil unit 210 that detects the approach or presence of the detection target, thereby dipping the detection coil unit 210 in the thermosetting resin in the front cover 20. Then, the pillar portion 69 is dipped in the thermosetting resin in the front cover 20 while the printed board 50 is inserted in the internal flow path 66G of the flow control member 66 until the end portion 69T of the pillar portion 69 comes close to or abuts on the core body 40. The thermosetting resin in the front cover 20 is cured by heating. The four pillar portions 69 are provided in the flow control member 66, so that the flow control member 66 can be fixed to the front cover 20 while the pillar portions 69 are partially dipped in the thermosetting resin without causing the front cover 20 to overflow.

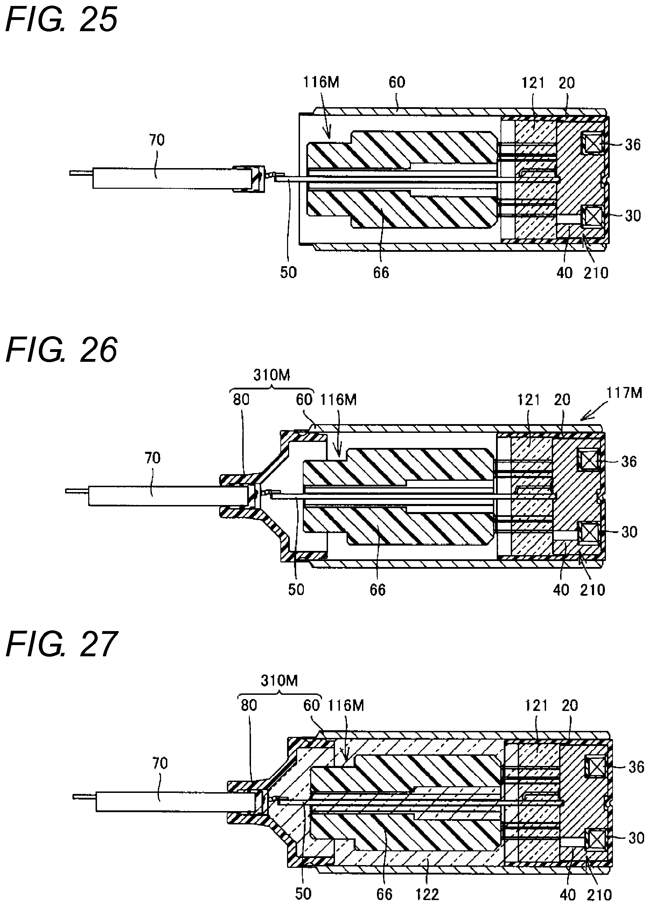

Referring to Fig. 24, the ring cord 70 is assembled in the sub-assembly 116M. Specifically, the leading end of the cable of the ring cord 70 is soldered onto the surface of the printed board 50. Referring to Fig. 25, the base metallic part 60 is assembled in the front cover 20. Specifically, the ring cord 70 and the printed board 50 are sequentially inserted from the front end side of the base metallic part 60, and the front cover 20 is press-fitted in the front end side of the base metallic part 60.

Referring to Fig. 26, the clamp 80 is assembled in the base metallic part 60. Specifically, the ring cord 70 is inserted from the front end side of the clamp 80, and the clamp 80 is press-fitted in the rear end side of the base metallic part 60. Then the base metallic part 60 and the clamp 80 are fixed to each other using fixing methods such as gouging, swaging, adhesion, and welding. Therefore, an assembly 117M is obtained. The process of fixing the base metallic part 60 and the clamp 80 to each other may be performed after a secondary filling process with resin subsequent thereto.

Referring to Fig. 27, the cylindrical case 310M including the base metallic part 60 and the clamp 80 is filled with the thermoplastic resin as a secondary filling resin. More specifically, the assembly 117M obtained through the process is set in a die using a positioning jig. The high-temperature resin is injected into the cylindrical case 310M through the gate 81 (see Figs. 1 and 4). The gate 81 is provided on the side (between the first end portion 310a and the first opening 66a of the flow control member 66) of the first end portion 310a from the portion in which the first opening 66a of the flow control member 66 is located in the extending direction of the center axis 102.

The high-temperature resin is branched into the resin flowing into the internal flow path 66G (the second flow path) of the flow control member 66 from the side of the first end portion 310a and the resin flowing into the external flow path or the first flow path between the outer surface 66n of the flow control member 66 and the inner surface 310k of the case member. The branched resins finally join together in the neighborhood of the front cover 20, and the internal space of the case member is substantially filled with the resin while an air bubble is confined in the resin. As described above, the resin flowing in and filling the external flow path through the gate 81 reaches the second opening 66b earlier than the resin flowing in and filling the internal flow path 66G through the gate 81. The thermoplastic resin portion 122 is formed by cooling and solidifying the thermoplastic resin. The printed board 50 and various electronic components in the cylindrical case 310M are sealed by the resin. The proximity sensor 530 in Fig. 1 is completed through the above processes.

### (Operation and effect)

In the proximity sensor 530, the detection coil unit 210 is sealed by the thermosetting resin portion 121. For example, an epoxy resin is used as the thermosetting resin portion 121. The core body 40 of the detection coil unit 210 includes a burned material such as ferrite. Assuming that the detection coil unit 210 is sealed by the thermoplastic resin portion, the externally-applied stress easily changes with time in the core body 40 and the electromagnetic coil 36, which constitute the detection coil unit 210. The intensity (magnetic flux density) of a magnetic field formed by the core body 40 and the electromagnetic coil 36 becomes easily unstable when the externally-applied stress increases or decreases. Specifically, when the stress applied to the core body 40 changes, a magnetic property of the core body 40 changes due to an influence of a magnetoelastic coupling (magnetic striction). When the stress applied to the core body 40 changes, a magnetic domain constituting the core body 40 changes, thereby changing the magnetic flux. When the stress applied to the core body 40 changes, sometimes a coil diameter or a distance between the coil wires changes. In this case, an L value or C value of the coil changes. The fluctuation of the property leads to fluctuation of detection sensitivity of the proximity sensor.

When the thermosetting resin is used as the resin sealing the detection coil unit 210, the stress applied to the detection coil unit 210 is stabilized for a long term compared with the use of the thermoplastic resin. For example, the stress applied to the detection coil unit 210 from the thermosetting resin portion 121 hardly changes immediately after the production of the proximity sensor 530, after the inspection of the proximity sensor 530, after the product shipment of the proximity sensor 530, and during the use of the proximity sensor 530. The proximity sensor 530 can detect the approach or presence of the detection target with stable sensitivity.

On the other hand, the printed board 50 is sealed by the thermoplastic resin portion 122. The resin having the hardness (shore D) of 60 or less is used as the thermoplastic resin portion 122. The stress remaining in the electronic device after the sealing can be reduced in the case that the sealing is performed using the low-hardness thermoplastic resin. Even if the printed board 50 is sealed using the thermoplastic resin portion 122, the stress applied to the printed board 50 after the sealing becomes smaller compared with the case that the printed board 50 is sealed using the thermosetting resin portion 121. According to the proximity sensor 530, the stress applied to the printed board 50 and the electronic components mounted on the printed board 50 can be reduced.

The proximity sensor 530 is sealed using the thermosetting resin portion 121 and the thermoplastic resin portion 122. The proximity sensor 530 can be produced in a shorter production time compared with the case that the inside of the proximity sensor is wholly sealed using the thermosetting resin portion.

As described above, the viscosity of the thermoplastic resin portion 122 ranges preferably from 500 mPa•s to 10000 mPa•s when being measured using the rheometer AR2000EX (a product of TA Instruments Japan Inc.) at a shearing speed of 10 (1/s) and a temperature of 190°C. The viscosity of the thermoplastic resin portion 122 ranges more preferably from 500 mPa•s to 8000 mPa•s when being measured using the rheometer AR2000EX (a product of TA Instruments Japan Inc.) at a shearing speed of 10 (1/s) and a temperature of 190°C. According to the configurations, the thermoplastic resin portion 122 can well adhere to the thermosetting resin portion 121 at an interface between the thermosetting resin portion 121 and the thermoplastic resin portion 122.

Referring to Fig. 28, it is assumed that the flow control member 66 is not provided in the proximity sensor. In this case, the thermoplastic resin injected in order to form the thermoplastic resin portion 122 shrinks as indicated by white arrows in Fig. 28 after the filling. A shrinkage amount of the thermoplastic resin is larger compared with the case that the flow control member 66 is provided in the proximity sensor. In the case that the flow control member 66 is not provided in the proximity sensor, the large stress is generated in association with the shrinkage, air is easily sucked in the proximity sensor from the fitting portion (the fitting portion between the base metallic part and the ring cord and the fitting portion between the base metallic part and the front cover) in association with the shrinkage of the resin, and the air bubble remains easily in the neighborhood of the fitting portion. In the case that air bubbles F1 to F3 remain in the proximity sensor, water is permitted to easily invade from the outside and therefore water-resistant performance is degraded.

It is assumed that the proximity sensor is placed in a high-temperature environment (for example, 70°C) in the case that the flow control member 66 is not provided in the proximity sensor. The thermoplastic resin portion 122 swells as indicated by black arrows in Fig. 28. A swelling amount of the thermoplastic resin portion 122 is larger compared with the case that the flow control member 66 is provided in the proximity sensor. In the case that the flow control member 66 is not provided in the proximity sensor, the large stress is generated in association with the swelling, the swelling of the resin deforms the end surface of the front cover 20 or generates the unnecessary gap in the fitting portion, and therefore the water-resistant performance is degraded. Sometimes the detection sensitivity is degraded in the case that the end surface of the front cover 20 is deformed.

In the case that the flow control member 66 is provided in the proximity sensor like the proximity sensor 530, even if the thermoplastic resin injected in order to form the thermoplastic resin portion 122 shrinks after the filling, the shrinkage amount of the thermoplastic resin is smaller compared with the case that the flow control member 66 is not provided in the proximity sensor. The suction of the air from the fitting portion into the proximity sensor is suppressed or prevented, and the high water-resistant performance can be obtained.

In the case that the flow control member 66 is provided in the proximity sensor like the proximity sensor 530, the swelling amount is smaller even if the proximity sensor 530 is placed in the high-temperature environment (for example, 70°C). The stress generated in association with the swelling is small, the deformation of the end surface of the front cover 20 or the generation of the unnecessary gap in the fitting portion is suppressed or prevented, and the high water-resistant performance can be obtained. The deformation of the end surface of the front cover 20 is suppressed, and the detection sensitivity is hardly degraded due to the deformation of the end surface of the front cover 20.

As described above, in the proximity sensor 530, the cross sectional shapes of the external flow path (the first flow path) and the internal flow path 66G (the second flow path) are formed such that the resin flowing in and filling the external flow path through the gate 81 reaches the second opening 66b earlier than the resin flowing in and filling the internal flow path 66G through the gate 81. In the embodiment, the sealing resin 120 (the thermoplastic resin portion 122A) formed between the inner surface 310k of the case member (the base metallic part 60) and the outer surface 66n of the flow control member 66 has the thickness of 2 mm to 4 mm, and a relationship of A : B = 3 to 37 : 1 holds for the first cross sectional shape of one of or all the positions in the extending direction of the flow control member 66. The area A is an area of the sealing resin 120 (the thermoplastic resin portion 122A) formed between the inner surface 310k of the case member (the base metallic part 60) and the outer surface 66n of the flow control member 66 in the first cross sectional shape when the cross sectional shape orthogonal to the extending direction of the flow control member 66 (in the embodiment, the extending direction of the center axis 102) is set to the first cross sectional shape. The area B is an area of the sealing resin 120 (the thermoplastic resin portion 122B) formed on the inside (the internal flow path 66G) of the flow control member 66 in the first cross sectional shape. During the flow, the thermoplastic resin injected through the gate 81 (see Figs. 1 and 4) in order to form the thermoplastic resin portion 122 is branched into the resin flowing into the internal flow path 66G of the flow control member 66 and the resin flowing into the outside of the flow control member 66.

Referring to Fig. 29, it is assumed that the cross sectional shapes of the external flow path (the first flow path) and the internal flow path 66G (the second flow path) are formed such that the resin flowing in and filling the external flow path through the gate 81 reaches the second opening 66b later than the resin flowing in and filling the internal flow path 66G through the gate 81. This is the case that the relationship of A: B = 3 to 37 : 1 does not hold. Assuming that the thermoplastic resin portion 122B formed in the internal flow path 66G of the flow control member 66 has the area of 1, the thermoplastic resin portion 122A formed outside the flow control member 66 has the area (the area ratio) less than 3. In this case, the flow path cross-section area of the internal flow path 66G is smaller than that outside the flow control member 66 in the area ratio. The thermoplastic resin injected through the gate 81 (see Figs. 1 and 4) in order to form the thermoplastic resin portion 122 flows fast not only the outside of the flow control member 66 but also the inside of the internal flow path 66G. During the filling, the thermoplastic resin flows as indicated by white arrows in Fig. 29.

In the case that the relationship of A: B = 3 to 37 : 1 does not hold, the thermoplastic resin flows fast also in the internal flow path 66G to easily push the air to the neighborhood of the fitting portion in which the front cover 20 is fitted in the base metallic part 60. The air bubble that cannot move due to the compression force of the filling pressure remains easily at a spot (a flow terminal) where the branched resins finally join together. In the case that air bubbles F4 and F5 remain in the neighborhood of the fitting portion, the water is permitted to invade from the outside, which leads to a variation in the water-resistant performance or the degradation in the water-resistant performance.

In the case where, like the proximity sensor 530, the sealing resin 120 (the thermoplastic resin portion 122A) formed between the inner surface 310k of the case member (the base metallic part 60) and the outer surface 66n of the flow control member 66 has the thickness of 2 mm to 4 mm and the relationship of A: B = 3 to 37 : 1 holds, fluidity of the thermoplastic resin can be obtained while an injection volume of the thermoplastic resin is suppressed, the thermoplastic resin injected through the gate 81 (see Figs. 1 and 4) flows fast in the outside of the flow control member 66, and the thermoplastic resin flows slow in the internal flow path 66G. The resin flowing in and filling the external flow path through the gate 81 reaches the second opening 66b earlier than the resin flowing in and filling the internal flow path 66G through the gate 81. Because the flow rate is faster on the outside, the air is hardly pushed to the neighborhood of the fitting portion in which the front cover 20 is fitted in the base metallic part 60. The remaining air bubble is suppressed in the spot (the neighborhood of the fitting portion) where the branched resins finally join together. According to the proximity sensor 530, the variation in the water-resistant performance or the degradation in the water-resistant performance can be suppressed.

Referring to Fig. 30, which shows a first embodiment of the invention, (and Fig. 13), as described above, the internal flow path 66G includes the first internal flow path 66G1 and the second internal flow path 66G2. The second internal flow path 66G2 has the flow path cross-section area larger than that of the first internal flow path 66G1. The cross sectional shape which is orthogonal to the extending direction of the second internal flow path 66G2 (in the embodiment, the extending direction of the center axis 102) and includes a portion in which the second internal flow path 66G2 is provided is referred to as a second cross sectional shape. In the embodiment, the shape illustrated in Fig. 13 is obtained as the second cross sectional shape.

In the second cross sectional shape, it is assumed that C is an area of the sealing resin 120 (a thermoplastic resin portion 122C in Fig. 13) formed in the first flow path or the external flow path between the inner surface 310k of the case member (the base metallic part 60) and the outer surface 66n of the flow control member 66. In the second cross sectional shape, it is assumed that D is an area of the sealing resin 120 (a thermoplastic resin portion 122D in Fig. 13) formed inside the second internal flow path 66G2 (the second flow path).

Preferably, a relationship of C : D = 1 to 7 : 1 holds with respect to the second cross sectional shape at one of or all the positions in the extending direction of the second internal flow path 66G2. In other words, assuming that the thermoplastic resin portion 122D formed in the second internal flow path 66G2 of the flow control member 66 has the area of 1, the thermoplastic resin portion 122D formed outside the flow control member 66 has the area (the area ratio) of 1 to 7. In the proximity sensor 530 of the embodiment, the relationship of C : D = 1 to 7 : 1 holds, and a step is formed between the second internal flow path 66G2 and the first internal flow path 66G1.

In the case that the relationship of C : D = 1 to 7 : 1 holds, the thermoplastic resin injected through the gate 81 (see Figs. 1 and 4) flows as indicated by the white arrows in Fig. 30 during the injection, and the thermoplastic resin easily invades in the internal flow path 66G from the side of the second opening 66b. The air is more easily pushed into the internal flow path 66G (the second internal flow path 66G2) than into the neighborhood of the fitting portion in which the front cover 20 is fitted in the base metallic part 60. The length L66G2 of the second internal flow path 66G2 ranges from 10% to 70% with respect to the length L66 (see Figs. 8 and 10) between the first opening 66a and the second opening 66b, which allows the higher effect to be obtained. According to the proximity sensor 530, the remaining air bubble in the neighborhood of the fitting portion is suppressed, and the variation in the water-resistant performance or the degradation in the water-resistant performance can further be suppressed.

### (Modification)

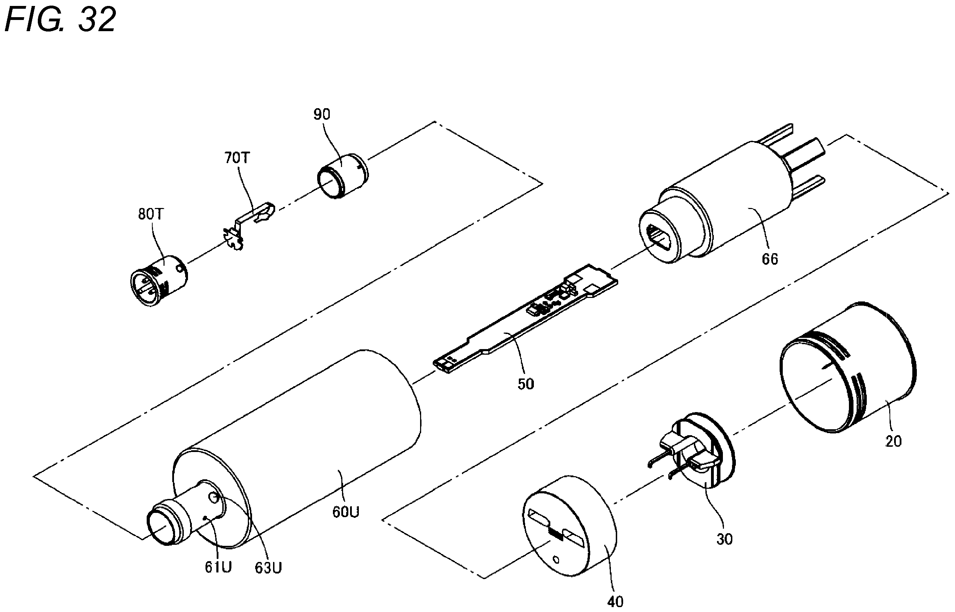

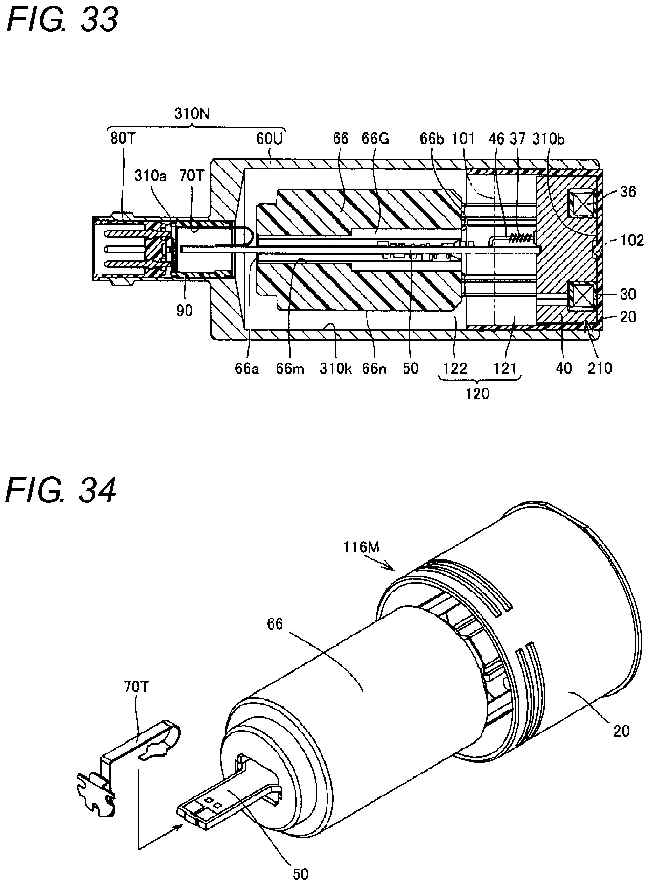

A proximity sensor 540 according to a modification of the proximity sensor 530 (see Fig. 1) will be described with reference to Figs. 31 to 33. In the modification, only a difference between the proximity sensor 530 and the proximity sensor 540 is described, but the overlapping description is neglected. Fig. 31 is a perspective view illustrating the proximity sensor 540. Fig. 32 is a perspective view illustrating a state in which the proximity sensor 540 is taken apart. Fig. 33 is a sectional view taken on a line XXXIII-XXXIII in Fig. 31.

Referring to Figs. 31 to 33, the proximity sensor 540 includes the detection coil unit 210 (see Fig. 33), the front cover 20, the printed board 50 (see Figs. 32 and 33), a base metallic part 60U, the flow control member 66, a harness 70T, a receptacle 80T, and a light emitting unit cover 90. The proximity sensor 530 are substantially identical to the proximity sensor 540 in the configurations of the detection coil unit 210, the front cover 20, the printed board 50, and the flow control member 66.

The base metallic part 60U is provided as the body case in which the electronic components such as the transistor, the diode, the resistor, and the capacitor are accommodated. The base metallic part 60U constitutes the outline of the proximity sensor 540 on the outer circumference of the center axis 102. The base metallic part 60U has the cylindrical shape that extends with the center axis 102 as the center. The base metallic part 60U extending along the center axis 102 is opened at both the ends. The front cover 20 is inserted in one of the opened ends of the base metallic part 60U, whereby the front cover 20 is fixed to the base metallic part 60U. For example, the base metallic part 60U has an inner diameter of at least 5 mm.

The base metallic part 60U is made of metal. A thread to be used to fix the proximity sensor 540 to the external facility is formed on the outer circumferential surface of the base metallic part 60U. A visible window 63U is formed in the base metallic part 60U as the opening through which the emission of the light emitting diode (not illustrated) mounted on the printed board 50 is recognized. A gate 61U is also formed in the base metallic part 60U. The gate 61U is provided as a through-hole through which the resin is injected into a cylindrical case 310N in producing the proximity sensor 540.

The proximity sensor 540 of the modification is what is called a sealed type proximity sensor in which the base metallic part 60U is disposed on the outer circumference of the detection coil unit 210. The proximity sensor 540 may be applied to what is called a non-sealed type proximity sensor in which the base metallic part 60U is disposed at the position deviated to the axial direction of the center axis 102 from the outer circumference of the detection coil unit 210.

The light emitting unit cover 90 has the cylindrical shape and is inserted (press-fitted) in the base metallic part 60U.

The light emitting unit cover 90 is made of resin. The light emitting unit cover 90 is made of a transparent or translucent resin such that the emission of the light emitting diode is visibly recognized from the outside of the proximity sensor 540. The light emitting unit cover 90 is disposed so as to be oriented toward the light emitting diode on the printed board 50, and the light emitting unit cover 90 is provided so as to close the visible window 63U. Because of the light emitting unit cover 90, the sealing resin 120 with which the base metallic part 60U is filled is not exposed to the external space through the visible window 63U.

The light emitting unit cover 90 is provided so as to be able to be inserted from the opened end of the base metallic part 60U. The light emitting unit cover 90 is not integral with the base metallic part 60U because of outsert molding, but the light emitting unit cover 90 is provided so as to be able to separate from the base metallic part 60U. In the proximity sensor 540, the thermoplastic resin is used as the resin sealing the electronic components in the base metallic part 60U. The thermoplastic resin exerts the low fluidity in filling the base metallic part 60U with the resin. Because the resin hardly flows between the inner circumferential surface of the base metallic part 60U and the light emitting unit cover 90, it is not necessary to adopt the outsert molding that is of a technique of bringing the inner circumferential surface of the base metallic part 60U and the light emitting unit cover 90 into close contact with each other. The configurations of the light emitting unit cover 90 and the base metallic part 60U are simplified to be able to reduce a production cost of the proximity sensor 540.

The receptacle 80T is provided so as to close the opened end on the rear end side of the cylindrical base metallic part 60U. The receptacle 80T is provided as a connector cover including a pin that connects the proximity sensor 540 to the outside. The receptacle 80T extends cylindrically with the center axis 102 as the center while being integral with the base metallic part 60U. The base metallic part 60U and the receptacle 80T constitute the cylindrical case 310N that extends cylindrically with the center axis 102 as the center. The printed board 50 and the electronic components mounted on the printed board 50 are accommodated in the cylindrical case 310N.

The harness 70T is a flexible wiring member. The harness 70T is provided in the base metallic part 60U as the wiring member that electrically connects the printed board 50 and the pin of the receptacle 80T. The harness 70T is connected to the pin of the receptacle 80T and the printed board 50 by the soldering.

### (Sealing resin 120)

In the cylindrical case 310N, the sealing resin 120 is formed by the injection of the resin. In the proximity sensor 540, the tubular case member in which the detection coil unit 210 and the printed board 50 are accommodated is constructed by the cylindrical case 310N, the receptacle 80T, and the front cover 20. The inner surface 310k of the case member includes the inner surface of the base metallic part 60, the inner surface of the receptacle 80T, and the inner surface of the front cover 20. The first end portion 310a is formed in the inner surface 310k on the side of the receptacle 80T, and the second end portion 310b is formed in the inner surface 310k on the side of the front cover 20.

The first end portion 310a is located at the circumferential edge of the opening in which the pin is attached in the inner surface of the receptacle 80T. In the inner surface of the front cover 20, the second end portion 310b is located in the front in the insertion direction of the core body 40. The second end portion 310b that is of the case member is closed by the front cover 20. The inner surface 310k of the case member in which the detection coil unit 210 and the printed board 50 are accommodated has the shape extending from the first end portion 310a toward the second end portion 310b (or the shape extending from the second end portion 310b toward the first end portion 310a).

The sealing resin 120 is provided such that the space of the case member surrounded by the cylindrical case 310N and the front cover 20 and the receptacle 80T, which close the front and rear ends of the cylindrical case 310N, is filled with the sealing resin 120. The sealing resin 120 seals the detection coil unit 210 accommodated in the front cover 20 and the printed board 50 and electronic components which are accommodated in the cylindrical case 310N.

The sealing resin 120 includes the thermosetting resin portion 121 and the thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion except the thermosetting resin portion 121 in the case member (the cylindrical case 310N, the receptacle 80T, and the front cover 20) to seal the printed board 50 and the electronic components. The thermoplastic resin having the hardness (shore D) of 60 or less is selected to form the thermoplastic resin portion 122. The thermoplastic resin portion 122 is formed by the solidification of the thermoplastic resin injected through the gate 61U after the thermoplastic resin flows in the flow path (the first flow path or the external flow path) formed between the inner surface 310k of the case member and the outer surface 66n of the flow control member 66 and spreads in the internal flow path 66G (the second flow path) constructed by the tubular internal space of the flow control member 66.

The thermosetting resin portion 121 and the thermoplastic resin portion 122 are provided so as to have the boundary in the front cover 20 indicated by the alternate long and two short dashes line 101 in Fig. 33. The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion extending from the front of the portion around which the leading end 37 of the electromagnetic coil 36 (the coil wire) is wound is sealed by the thermoplastic resin portion 122.

In the coil pin 46, the portion soldered to the pattern of the printed board 50 is sealed by the thermoplastic resin portion 122. Alternatively, in the coil pin 46, the portion extending from the front of the portion around which the leading end 37 of the electromagnetic coil 36 (the coil wire) is wound may be sealed by the thermosetting resin portion 121. In this case, in the coil pin 46, the portion soldered to the pattern of the printed board 50 is sealed by the thermosetting resin portion 121.

The thermoplastic resin that can be molded at low temperature and low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having the hardness (shore D) of 60 or less can reduce stress applied to the internal device due to heat and pressure during the filling of the resin, eliminate necessity for reaction curing, and shorten a process tact time.

An epoxy resin can be cited as a typical example of the thermosetting resin used to form the thermosetting resin portion 121. Preferably the thermosetting resin portion 121 has a small fluctuation in resin stress (stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121.

The sealing resin 120 is not limited to the two-stage segmentation structure including the thermosetting resin portion 121 and the thermoplastic resin portion 122, but the sealing resin 120 may have a segmentation structure of at least three stages. In the case that the sealing resin 120 has the segmentation structure, the resin constituting each layer may be a combination of the identical kind of resin of one of the thermoplastic resin and the thermosetting resin. The sealing resin 120 is not limited to the segmentation structure, but the sealing resin 120 may have a structure in which the detection coil unit 210, the printed board 50, and the electronic components are collectively sealed by one of the thermoplastic resin and the thermosetting resin.

The viscosity of the thermoplastic resin portion 122 ranges preferably from 500 mPa•s to 10000 mPa•s when being measured using the rheometer AR2000EX (a product of TA Instruments Japan Inc.) at a shearing speed of 10 (1/s) and a temperature of 190°C. The viscosity of the thermoplastic resin portion 122 ranges more preferably from 500 mPa•s to 8000 mPa•s when being measured using the rheometer AR2000EX (a product of TA Instruments Japan Inc.) at a shearing speed of 10 (1/s) and a temperature of 190°C.

### (Producing method)

A method for producing the proximity sensor 540 (see Fig. 31) will be described with reference to Figs. 34 to 36. Referring to Fig. 34, the sub-assembly 116M including the detection coil unit 210 and the printed board 50 is assembled (similarly to the case described with reference to Fig. 22). The front cover 20 and the flow control member 66 are assembled in the sub-assembly 116M (similarly to the case described with reference to Fig. 23).

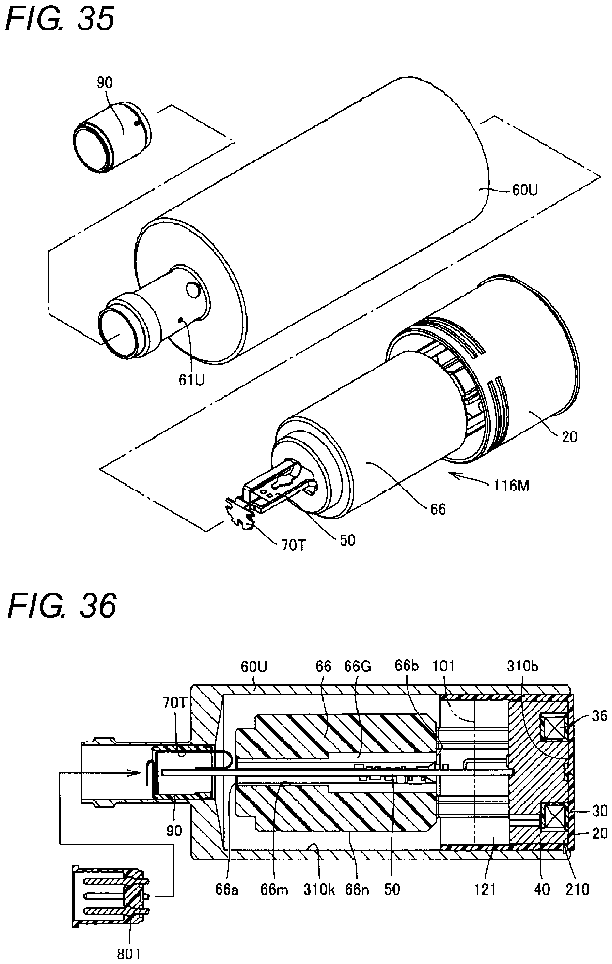

Then the harness 70T is assembled in the sub-assembly 116M. Specifically, the harness 70T is soldered onto the surface of the printed board 50. Referring to Fig. 35, the base metallic part 60U is assembled in the front cover 20. Specifically, the harness 70T and the printed board 500 are sequentially inserted from the front end side of the base metallic part 60U, and the front cover 20 is press-fitted in the front end side of the base metallic part 60U. Then the light emitting unit cover 90 is press-fitted in the base metallic part 60U from the opening on the rear end side of the base metallic part 60U.

Referring to Fig. 36, the receptacle 80T is assembled in the base metallic part 60U. Specifically, the receptacle 80T is press-fitted in the rear end side of the base metallic part 60U. Then the base metallic part 60 and the receptacle 80T are fixed to each other using fixing methods such as the gouging, the swaging, the adhesion, and the welding. The process of fixing the base metallic part 60U and the receptacle 80T to each other may be performed after the secondary filling process with resin subsequent thereto.

Then the cylindrical case 310N (see Fig. 33) including the base metallic part 60U and the receptacle 80T is filled with the thermoplastic resin as the secondary filling resin. More specifically, the assembly obtained through the process is set in the die using the positioning jig. The high-temperature resin is injected into the cylindrical case 310N through the gate 61T (see Fig. 31). The gate 61U is provided on the side (between the first end portion 310a and the first opening 66a of the flow control member 66) of the first end portion 310a from the portion in which the first opening 66a of the flow control member 66 is located in the extending direction of the center axis 102. The high-temperature resin is branched into the resin flowing into the internal flow path 66G (the second flow path) of the flow control member 66 from the side of the first end portion 310a and the resin flowing into the external flow path or the first flow path between the outer surface 66n of the flow control member 66 and the inner surface 310k of the case member. The branched resins finally join together in the neighborhood of the front cover 20, and the internal space of the case member is substantially filled with the resin while an air bubble is confined in the resin. The resin flowing in and filling the external flow path through the gate 61U reaches the second opening 66b earlier than the resin flowing in and filling the internal flow path 66G through the gate 61U. The thermoplastic resin portion 122 (see Fig. 33) is formed by cooling and solidifying the thermoplastic resin. The printed board 50 and various electronic components in the cylindrical case 310N are sealed by the resin. The proximity sensor 540 in Fig. 31 is completed through the above processes.

### (Operation and effect)

In the proximity sensor 540, similarly the detection coil unit 210 is sealed by the thermosetting resin portion 121. The stress applied to the detection coil unit 210 is stabilized for a long term compared with the case that the detection coil unit 210 is sealed using the thermoplastic resin portion. The proximity sensor 540 can detect the approach or presence of the detection target with the stable sensitivity.

On the other hand, the printed board 50 is sealed by the thermoplastic resin portion 122. The resin having the hardness (shore D) of 60 or less is used as the thermoplastic resin portion 122. According to the proximity sensor 540, similarly the stress applied to the printed board 50 and the electronic components mounted on the printed board 50 can be reduced. The proximity sensor 540 can be produced in a shorter production time compared with the case that the inside of the proximity sensor is wholly sealed using the thermosetting resin portion.

In the case that the flow control member 66 is provided in the proximity sensor like the proximity sensor 540, even if the thermoplastic resin injected in order to form the thermoplastic resin portion 122 shrinks after the filling, the shrinkage amount of the thermoplastic resin is smaller compared with the case that the flow control member 66 is not provided in the proximity sensor. The suction of the air from the fitting portion into the proximity sensor is suppressed or prevented, and the high water-resistant performance can be obtained.

In the case that the flow control member 66 is provided in the proximity sensor like the proximity sensor 540, the swelling amount is smaller even if the proximity sensor 540 is placed in the high-temperature environment (for example, 70°C). The stress generated in association with the swelling is small, the deformation of the end surface of the front cover 20 or the generation of the unnecessary gap in the fitting portion is suppressed or prevented, and the high water-resistant performance can be obtained. The deformation of the end surface of the front cover 20 is suppressed, and the detection sensitivity is hardly degraded due to the deformation of the end surface of the front cover 20.

In the proximity sensor 540, the cross sectional shapes of the external flow path (the first flow path) and the internal flow path 66G (the second flow path) are formed such that the resin flowing in and filling the external flow path through the gate 61U reaches the second opening 66b earlier than the resin flowing in and filling the internal flow path 66G through the gate 61U. In the embodiment, the sealing resin 120 (the thermoplastic resin portion 122) formed between the inner surface 310k of the case member (the base metallic part 60U) and the outer surface 66n of the flow control member 66 has the thickness of 2 mm to 4 mm, and the relationship of A : B = 3 to 37 : 1 holds for the first cross sectional shape of one of or all the positions in the extending direction of the flow control member 66. The resin flowing in and filling the external flow path through the gate 61U reaches the second opening 66b earlier than the resin flowing in and filling the internal flow path 66G through the gate 61U. The fluidity of the thermoplastic resin can be obtained while the injection volume of the thermoplastic resin is suppressed, the thermoplastic resin injected through the gate 61U flows fast in the outside of the flow control member 66, and the thermoplastic resin flows slow in the internal flow path 66G. Because the flow rate is faster on the outside, the air is hardly pushed to the neighborhood of the fitting portion in which the front cover 20 is fitted in the base metallic part 60U. The remaining air bubble is suppressed in the spot (the neighborhood of the fitting portion) where the branched resins finally join together. According to the proximity sensor 540, the variation in the water-resistant performance or the degradation in the water-resistant performance can be suppressed.

Preferably, similarly to the proximity sensor 530, the relationship of C : D = 1 to 7 : 1 holds with respect to the second cross sectional shape at one of or all the positions in the extending direction of the second internal flow path 66G2. The thermoplastic resin injected through the gate 61U invades easily into the internal flow path 66G from the side of the second opening 66b. The remaining air bubble in the neighborhood of the fitting portion is suppressed, and the variation in the water-resistant performance or the degradation in the water-resistant performance can further be suppressed.

### [Experimental example 1]

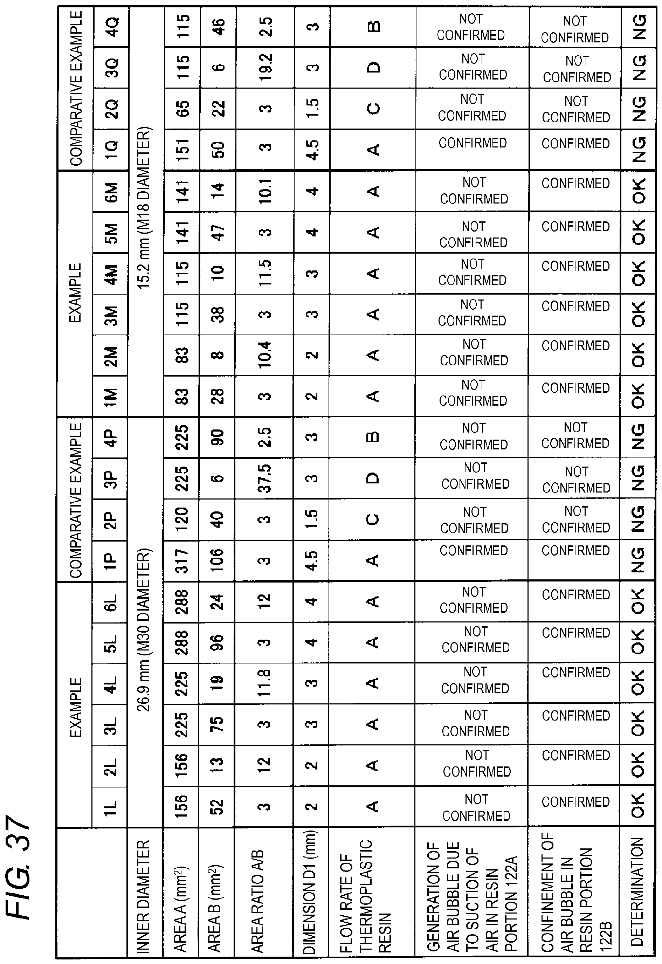

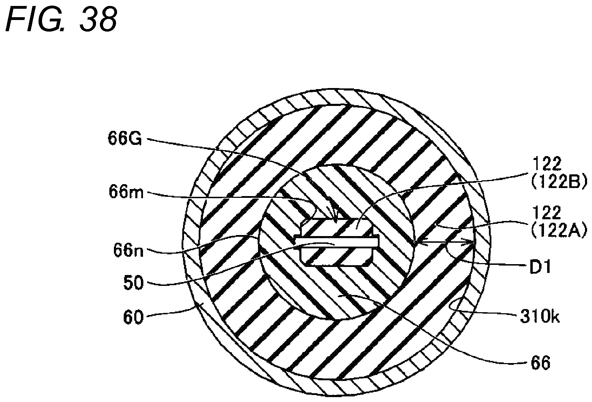

Experimental example 1 performed to the embodiment will be described below with reference to Figs. 37 and 38. The Experimental example 1 includes Examples 1L to 6L and 1M to 6M and Comparative examples 1P to 4P and 1Q to 4Q. In Experimental example 1, the assembly 117M in Fig. 26 was prepared. In the assembly 117M used in Experimental example 1, the printed board 50 and the like were accommodated and disposed at predetermined positions, and the minimum dimension between the printed board 50 and the inner surface 66m of the flow control member 66 was set to 0.5 mm or more. This is based on a flow limit of the thermoplastic resin forming the thermoplastic resin portion 122. The thermoplastic resin portion 122 is not formed in the assembly 117.

The cross-section area (the area A) in the first cross sectional shape of the thermoplastic resin portion 122 (122A) formed between the outer surface 66n of the flow control member 66 and the inner surface 310k of the case member (the base metallic part 60) by the injection of the thermoplastic resin varied in each of Examples 1L to 6L and 1M to 6M and Comparative examples 1P to 4P and 1Q to 4Q (see Fig. 37). The cross-section area (the area B) in the first cross sectional shape of the thermoplastic resin portion 122 (122B) formed in the internal flow path 66G (inside the flow control member 66) of the flow control member 66 by the injection of the thermoplastic resin also varied in each of Examples 1L to 6L and 1M to 6M and Comparative examples 1P to 4P and 1Q to 4Q (see Fig. 37).

In each of Examples 1L to 6L and 1M to 6M and Comparative examples 1P to 4P and 1Q to 4Q, the outer surface 66n of the flow control member 66 and the inner surface 310k of the case member (the base metallic part 60) have the circle shape when viewed as the first cross sectional shape. The base metallic part 60 having an inner diameter of 26.9 mm and an external dimension of 30 mm (M30) was used in Examples 1L to 6L and Comparative examples 1P to 4P. The base metallic part 60 having the inner diameter of 15.2 mm and the external dimension of 18 mm (M18) was used in Examples 1M to 6M and Comparative examples 1Q to 4Q. In each of Examples 1L to 6L and 1M to 6M and Comparative examples 1P to 4P and 1Q to 4Q, a difference in diameter between the outer surface 66n and the inner surface 310k is indicated as a dimension D1 in Figs. 37 and 38.

In each of Examples 1L to 6L and 1M to 6M and Comparative examples 1P to 4P and 1Q to 4Q, the thermoplastic resin having the identical property (viscosity) was prepared as the thermoplastic resin forming the thermoplastic resin portion 122. In each of Examples 1L to 6L and 1M to 6M and Comparative examples 1P to 4P and 1Q to 4Q, whether the air bubble was generated by the suction of the air in the thermoplastic resin portion 122A was checked when the assembly 117M was filled with the thermoplastic resin, and whether the air bubble was confined in the thermoplastic resin portion 122B was checked.

In Fig. 38, the flow rate of the thermoplastic resin injected from the gate is also described for each of Examples 1L to 6L and 1M to 6M and Comparative examples 1P to 4P and 1Q to 4Q. The description includes evaluations A to D. For the proximity sensors prepared as Examples 1L to 6L and 1M to 6M and Comparative examples 1P to 4P and 1Q to 4Q, the evaluation A is the case that the flow rate of the thermoplastic resin flowing in the flow path (the external flow path or the first flow path) corresponding to the thermoplastic resin portion 122A is faster than that of the thermoplastic resin flowing in the flow path (the internal flow path or the second flow path) corresponding to the thermoplastic resin portion 122B.

The evaluation B is the case that the flow rate of the thermoplastic resin flowing in the flow path (the external flow path or the first flow path) corresponding to the thermoplastic resin portion 122A is less than or equal to that of the thermoplastic resin flowing in the flow path (the internal flow path or the second flow path) corresponding to the thermoplastic resin portion 122B. The evaluation C is the case that the thermoplastic resin does not properly flow in the flow path (the external flow path or the first flow path) corresponding to the thermoplastic resin portion 122A. The evaluation D is the case that the thermoplastic resin does not properly flow in the flow path (the internal flow path or the second flow path) corresponding to the thermoplastic resin portion 122B.

### (Examples 1L to 6L)

In Example 1L, the area ratio (A/B) obtained from the areas A and B was set to 3, and the dimension D1 was set to 2 mm. In Example 2L, the area ratio (A/B) obtained from the areas A and B was set to 12, and the dimension D1 was set to 2 mm. In Example 3L, the area ratio (A/B) obtained from the areas A and B was set to 3, and the dimension D1 was set to 3 mm. In Example 4L, the area ratio (A/B) obtained from the areas A and B was set to 11.8, and the dimension D1 was set to 3 mm. In Example 5L, the area ratio (A/B) obtained from the areas A and B was set to 3, and the dimension D1 was set to 4 mm. In Example 6L, the area ratio (A/B) obtained from the areas A and B was set to 12, and the dimension D1 was set to 4 mm.

A result (the evaluation A) that the flow rate of the thermoplastic resin flowing in the external flow path was faster than that of the thermoplastic resin flowing in the internal flow path was obtained in Examples 1L to 6L. In Examples 1L to 6L, the air bubble caused by the suction of the air in the thermoplastic resin portion 122A was not generated, but the confinement of the air bubble in the thermoplastic resin portion 122B was confirmed. The sealing resin formed between the inner surface of the case member (the base metallic part) and the outer surface of the flow control member has the thickness of 2 mm to 4 mm, and the relationship of A : B = 3 to 37 : 1 holds for the area ratio of the thermoplastic resin portion 122B (the area B) to the thermoplastic resin portion 122A (the area A). Because the flow rate is faster on the outside, the air is hardly pushed to the neighborhood of the fitting portion in which the front cover 20 is fitted in the base metallic part 60, and the remaining air bubble in the spot (near the fitting portion) where the branched resins finally join together is also suppressed. The non-defective determination (OK) was made for Examples 1L to 6L.

### (Comparative examples 1P to 4P)

In Comparative example 1P, the area ratio (A/B) obtained from the areas A and B was set to 3, and the dimension D1 was set to 4.5 mm. The result (the evaluation A) that the flow rate of the thermoplastic resin flowing in the external flow path was faster than that of the thermoplastic resin flowing in the internal flow path was obtained in Comparative example 1P. In Comparative example 1P, the air bubble caused by the suction of the air in the thermoplastic resin portion 122A was generated while the confinement of the air bubble in the thermoplastic resin portion 122B was confirmed. This is attributed to the fact that the shrinkage stress of the thermoplastic resin increased because the dimension D1 was large beyond necessity. The defective determination (NG) was made for Comparative example 1P.

In Comparative example 2P, the area ratio (A/B) obtained from the areas A and B was set to 3, and the dimension D1 was set to 1.5 mm. The result (the evaluation C) that the thermoplastic resin did not properly flow in the flow path (the external flow path or the first flow path) corresponding to the thermoplastic resin portion 122A was obtained in Comparative example 2P. In Comparative example 2P, the confinement of the air bubble in the thermoplastic resin portion 122B was not confirmed while the air bubble caused by the suction of the air in the thermoplastic resin portion 122A was not generated. This is attributed to the fact that the thermoplastic resin stopped in the external flow path because the dimension D1 was small beyond necessity. The defective determination (NG) was made for Comparative example 2P.

In Comparative example 3P, the area ratio (A/B) obtained from the areas A and B was set to 37.5, and the dimension D1 was set to 3 mm. The result (the evaluation D) that the thermoplastic resin did not properly flow in the flow path (the internal flow path or the second flow path) corresponding to the thermoplastic resin portion 122B was obtained in Comparative example 3P. In Comparative example 3P, the confinement of the air bubble in the thermoplastic resin portion 122B was not confirmed while the air bubble caused by the suction of the air in the thermoplastic resin portion 122A was not generated. This is attributed to the fact that the thermoplastic resin did not flow in the internal flow path but the air bubble remained in the neighborhood of the fitting portion of the thermoplastic resin portion 122A. The defective determination (NG) was made for Comparative example 3P.

In Comparative example 4P, the area ratio (A/B) obtained from the areas A and B was set to 2.5, and the dimension D1 was set to 3 mm. The result (the evaluation B) that the flow rate of the thermoplastic resin flowing in the external flow path was less than or equal to that of the thermoplastic resin flowing in the internal flow path was obtained in Comparative example 4P. In Comparative example 4P, the confinement of the air bubble in the thermoplastic resin portion 122B was not confirmed while the air bubble caused by the suction of the air in the thermoplastic resin portion 122A was not generated. This is attributed to the fact that the thermoplastic resin flowed fast in the internal flow path and the air bubble remained in the neighborhood of the fitting portion of the thermoplastic resin portion 122A. The defective determination (NG) was made for Comparative example 4P.

### (Examples 1M to 6M)

In Example 1M, the area ratio (A/B) obtained from the areas A and B was set to 3, and the dimension D1 was set to 2 mm. In Example 2M, the area ratio (A/B) obtained from the areas A and B was set to 10.4, and the dimension D1 was set to 2 mm. In Example 3M, the area ratio (A/B) obtained from the areas A and B was set to 3, and the dimension D1 was set to 3 mm. In Example 4M, the area ratio (A/B) obtained from the areas A and B was set to 11.5, and the dimension D1 was set to 3 mm. In Example 5M, the area ratio (A/B) obtained from the areas A and B was set to 3, and the dimension D1 was set to 4 mm. In Example 6M, the area ratio (A/B) obtained from the areas A and B was set to 10.1, and the dimension D1 was set to 4 mm.

The result (the evaluation A) that the flow rate of the thermoplastic resin flowing in the external flow path was faster than that of the thermoplastic resin flowing in the internal flow path was obtained in Examples 1M to 6M. In Examples 1M to 6M, the air bubble caused by the suction of the air in the thermoplastic resin portion 122A was not generated, but the confinement of the air bubble in the thermoplastic resin portion 122B was confirmed. The sealing resin formed between the inner surface of the case member (the base metallic part) and the outer surface of the flow control member has the thickness of 2 mm to 4 mm, and the relationship of A : B = 3 to 37 : 1 holds for the area ratio of the thermoplastic resin portion 122B (the area B) to the thermoplastic resin portion 122A (the area A). Because the flow rate is faster on the outside, the air is hardly pushed to the neighborhood of the fitting portion in which the front cover 20 is fitted in the base metallic part 60, and the remaining air bubble in the spot (near the fitting portion) where the branched resins finally join together is also suppressed. The non-defective determination (OK) was made for Examples 1M to 6M.

### (Comparative examples 1Q to 4Q)

In Comparative example 1Q, the area ratio (A/B) obtained from the areas A and B was set to 3, and the dimension D1 was set to 4.5 mm. The result (the evaluation A) that the flow rate of the thermoplastic resin flowing in the external flow path was faster than that of the thermoplastic resin flowing in the internal flow path was obtained in Comparative example 1Q. In Comparative example 1Q, the air bubble caused by the suction of the air in the thermoplastic resin portion 122A was generated while the confinement of the air bubble in the thermoplastic resin portion 122B was confirmed. This is attributed to the fact that the shrinkage stress of the thermoplastic resin increased because the dimension D1 was large beyond necessity. The defective determination (NG) was made for Comparative example 1Q.

In Comparative example 2Q, the area ratio (A/B) obtained from the areas A and B was set to 3, and the dimension D1 was set to 1.5 mm. The result (the evaluation C) that the thermoplastic resin did not properly flow in the flow path (the external flow path or the first flow path) corresponding to the thermoplastic resin portion 122A was obtained in Comparative example 2Q. In Comparative example 2Q, the confinement of the air bubble in the thermoplastic resin portion 122B was not confirmed while the air bubble caused by the suction of the air in the thermoplastic resin portion 122A was not generated. This is attributed to the fact that the thermoplastic resin stopped in the external flow path because the dimension D1 was small beyond necessity. The defective determination (NG) was made for Comparative example 2Q.

In Comparative example 3Q, the area ratio (A/B) obtained from the areas A and B was set to 19.2, and the dimension D1 was set to 3 mm. The result (the evaluation D) that the thermoplastic resin did not properly flow in the flow path (the internal flow path or the second flow path) corresponding to the thermoplastic resin portion 122B was obtained in Comparative example 3Q. In Comparative example 3Q, the confinement of the air bubble in the thermoplastic resin portion 122B was not confirmed while the air bubble caused by the suction of the air in the thermoplastic resin portion 122A was not generated. This is attributed to the fact that the thermoplastic resin did not flow in the internal flow path but the air bubble remained in the neighborhood of the fitting portion of the thermoplastic resin portion 122A. The defective determination (NG) was made for Comparative example 3P.

In Comparative example 4Q, the area ratio (A/B) obtained from the areas A and B was set to 2.5, and the dimension D1 was set to 3 mm. The result (the evaluation B) that the flow rate of the thermoplastic resin flowing in the external flow path was less than or equal to that of the thermoplastic resin flowing in the internal flow path was obtained in Comparative example 4Q. In Comparative example 4Q, the confinement of the air bubble in the thermoplastic resin portion 122B was not confirmed while the air bubble caused by the suction of the air in the thermoplastic resin portion 122A was not generated. This is attributed to the fact that the thermoplastic resin flowed fast in the internal flow path and the air bubble remained in the neighborhood of the fitting portion of the thermoplastic resin portion 122A. The defective determination (NG) was made for Comparative example 4Q.

### [Experimental example 2]

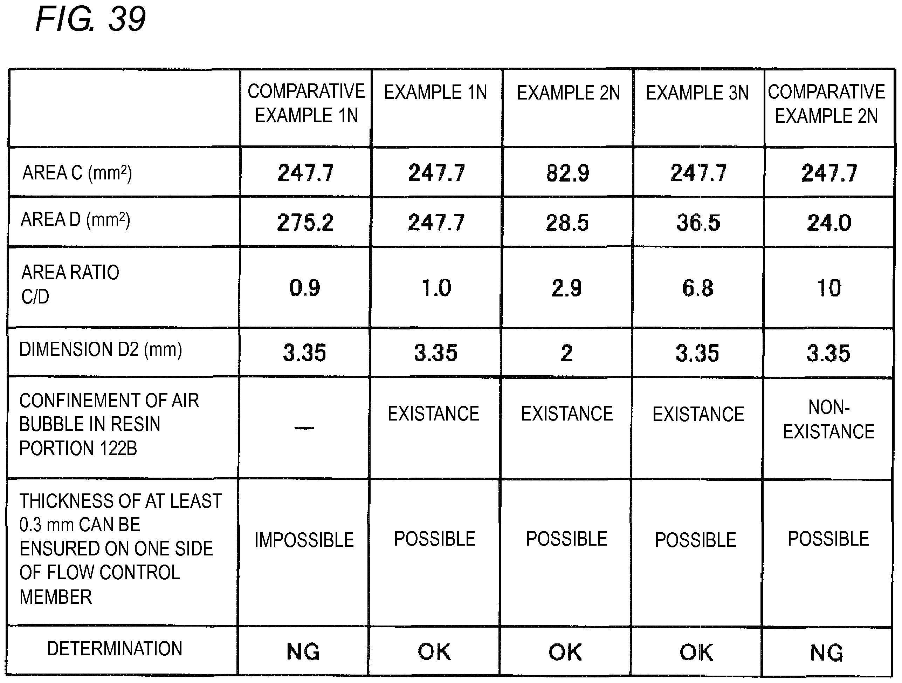

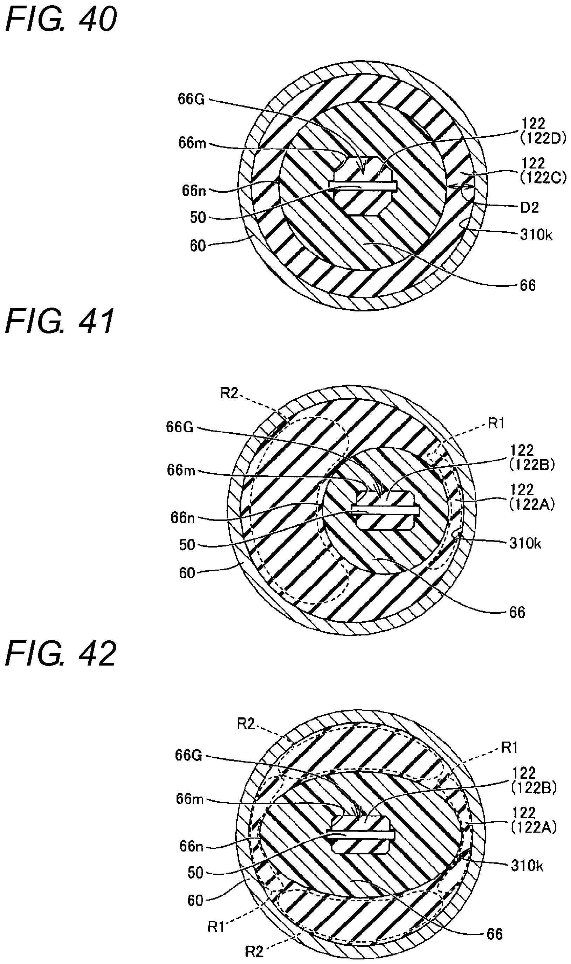

Experimental example 2 performed to the embodiment will be described below with reference to Figs. 39 and 40. Experimental example 2 includes Comparative examples 1N and 2N and Examples 1M, 2M, and 3M. In Experimental example 2, the assembly 117M (see Fig. 26) used in Experimental example 1 was prepared.

The cross-section area (the area C) in the second cross sectional shape of the thermoplastic resin portion 122 (122A) formed between the outer surface 66n of the flow control member 66 and the inner surface 310k of the case member (the base metallic part 60) by the injection of the thermoplastic resin varied in each of Comparative examples 1N and 2N and Examples 1N, 2N, and 3N (see Fig. 40). The cross-section area (the area D) in the second cross sectional shape of the thermoplastic resin portion 122 (122B) formed in the internal flow path 66G (inside the flow control member 66) of the flow control member 66 by the injection of the thermoplastic resin also varied in each of Comparative examples 1N and 2N and Examples 1N, 2N, and 3N (see Fig. 40).

In each of Comparative examples 1N and 2N and Examples 1N, 2N, and 3N, the outer surface 66n of the flow control member 66 and the inner surface 310k of the case member (the base metallic part 60) have the circle shape when viewed as the second cross sectional shape. In each of Comparative examples 1N and 2N and Examples 1N, 2N, and 3N, the difference in diameter between the outer surface 66n and the inner surface 310k is described as a dimension D2 in Figs. 39 and 40.

In each of Comparative examples 1N and 2N and Examples 1N, 2N, and 3N, the thermoplastic resin having the identical property (viscosity) was prepared as the thermoplastic resin forming the thermoplastic resin portion 122. In each of Comparative examples 1N and 2N and Examples 1N, 2N, and 3N, whether the air bubble was confined in the thermoplastic resin portion 122B was checked when the assembly 117M was filled with the thermoplastic resin. Whether the thickness of at least 0.3 mm can be ensured on one side of the flow control member 66 is also described in Fig. 39.

In Comparative example 1N, the area ratio (C/D) obtained from the areas C and D was set to 0.9, and the dimension D2 was set to 3.35 mm. In Comparative example 1N, the confinement of the air bubble in the thermoplastic resin portion 122B was not confirmed, and the thickness of at least 0.3 mm was not able to be ensured on one side of the flow control member 66. The defective determination (NG) was made for Comparative example 1N.

In Example 1N, the area ratio (C/D) obtained from the areas C and D was set to 1.0, and the dimension D2 was set to 3.35 mm. In Example 2N, the area ratio (C/D) obtained from the areas C and D was set to 2.9, and the dimension D2 was set to 2 mm. In Example 3N, the area ratio (C/D) obtained from the areas C and D was set to 6.8, and the dimension D2 was set to 3.35 mm. In Examples 1N, 2N, and 3N, the confinement of the air bubble in the thermoplastic resin portion 122B was generated, the thickness of at least 0.3 mm was able to be ensured on one side of the flow control member 66, and each flow control member 66 was able to be easily prepared. The non-defective determination (OK) was made for Examples 1N to 3N.

In Comparative example 1N, the area ratio (C/D) obtained from the areas C and D was set to 10, and the dimension D2 was set to 3.35 mm. In Comparative example 2N, the thickness of at least 0.3 mm was able to be ensured on one side of the flow control member 66, but the confinement of the air bubble in the thermoplastic resin portion 122B was not generated. The defective determination (NG) was made for Comparative example 2N.

### (Other modifications)

Referring to Fig. 41, as described above, the flow control member 66 may be disposed coaxially with the center axis (in the embodiment, the center axis 102) of the inner surface 310k of the case member. This is because a difference in flow of the thermoplastic resin is generated between a region R1 and a region R2 when the flow control member 66 is deviated with respect to the inner surface 310k as illustrated in Fig. 41.

Referring to Fig. 42, the shape of the outer surface 66n of the flow control member 66 may be similar to that of the inner surface 310k of the case member. This is because the difference in flow of the thermoplastic resin is generated between the region R1 and the region R2 when the outer surface 66n has an elliptical shape while the inner surface 310k has the circle shape as illustrated in Fig. 42. Preferably, the cross sectional shape of the outer surface 66n of the flow control member 66 may have the circle shape corresponding to the shape of the inner surface 310k.

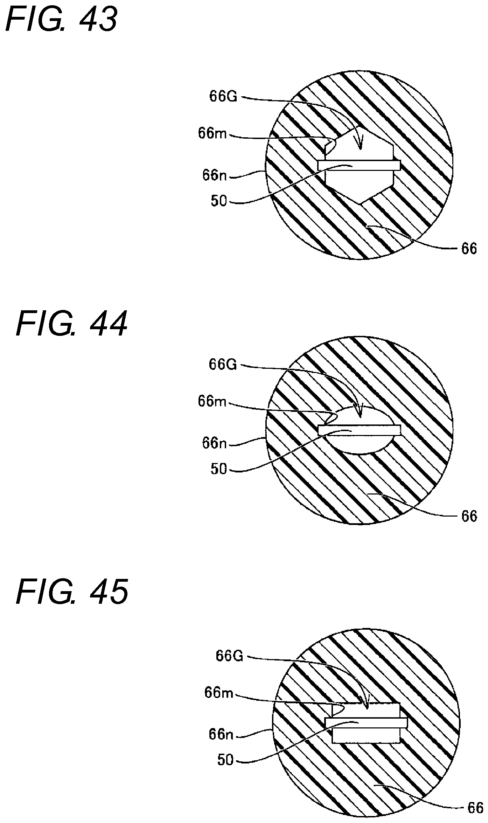

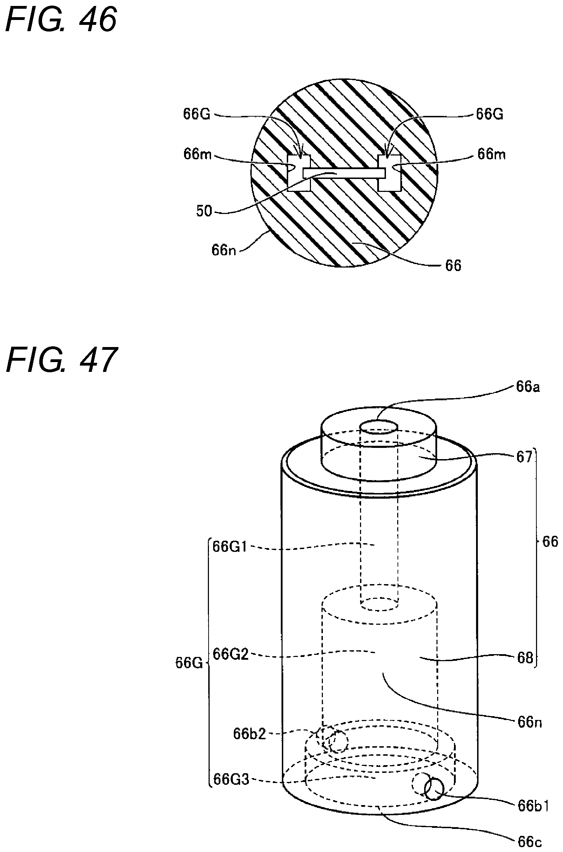

Referring to Figs. 43 to 46, the inside of the flow control member 66 may have a regular hexagon shape (see Fig. 43), the elliptical shape (see Fig. 44), a rectangular shape (see Fig. 45), or other polygonal shape (see Fig. 46). The inside of the flow control member 66 may have any shape.

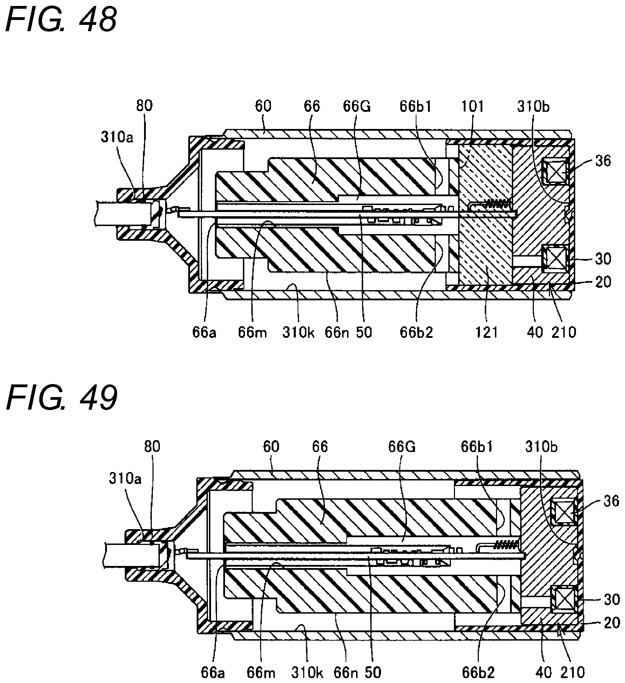

Referring to Figs. 47 and 48, the flow control member 66 of the embodiment includes the small diameter portion 67, the large diameter portion 68, and the four pillar portions 69. As illustrated in Fig. 47, the four pillar portions 69 are not necessarily provided although the four pillar portions 69 may preferably be provided. In the case that the four pillar portions 69 are not provided, openings 66b1 and 66b2 are provided as the second opening as illustrated in Fig. 47. The openings 66b1 and 66b2 may have an opening area equivalent to an opening area of ϕ0.5 mm or more. An opening 66c located on the opposite side to the first opening 66a does not act as the second opening in the modification (see Fig. 48).

In the flow control member 66 in Fig. 47, the internal flow path 66G includes the first internal flow path 66G1, the second internal flow path 66G2, and a second internal flow path 66G3. In the configuration in Fig. 47, the operation and effect identical to those of the embodiment can be obtained.

Referring to Fig. 49, in the embodiment, the sealing resin 120 includes the thermosetting resin portion 121 and the thermoplastic resin portion 122. The sealing resin 120 may be made of one kind of the resin. Fig. 49 illustrates the pre-injection state of the sealing resin 120.

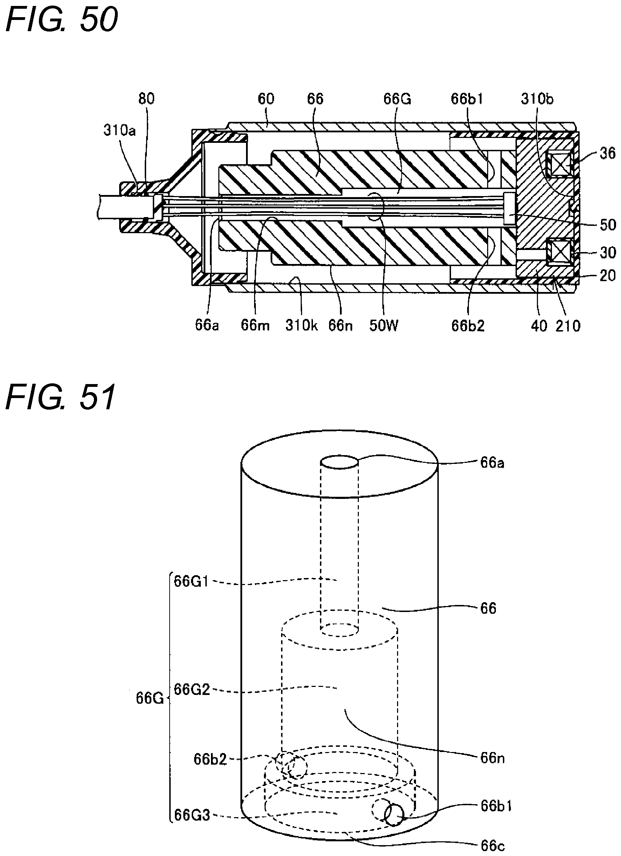

Referring to Fig. 50, not the printed board 50 but a wiring member 50W may be disposed in the internal flow path 66G of the flow control member 66. The relationship of A : B = 3 to 37 : 1 and the relationship of C : D = 1 to 7 : 1 may hold according to the cross-section area of the wiring member 50W.

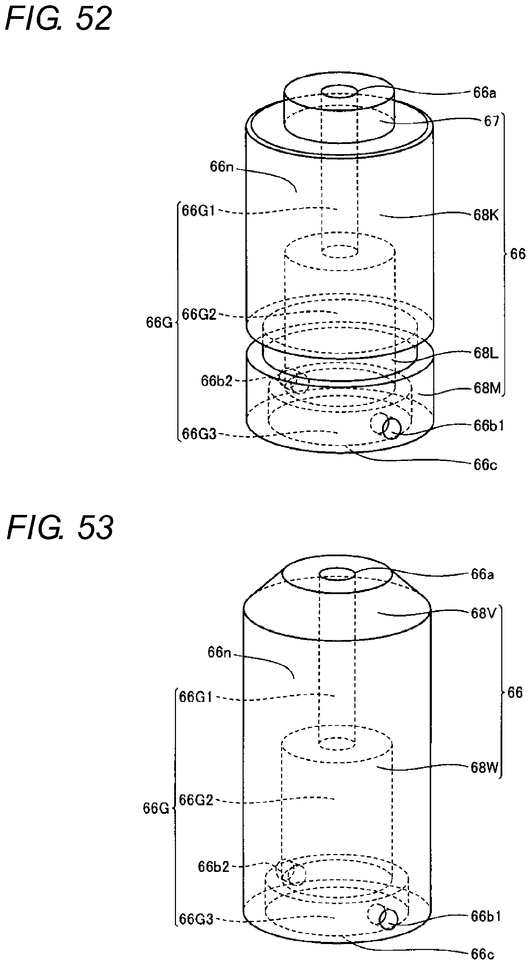

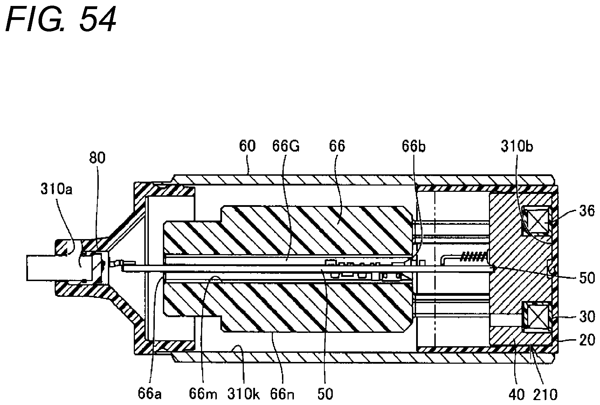

Referring to Fig. 51, the flow control member 66 of the embodiment includes the small diameter portion 67 and the large diameter portion 68. Like the flow control member 66 in Fig. 51, the step may not exist in the outer surface 66n of the flow control member 66. Like the flow control member 66 in Fig. 52, a constricted portion 68L may be formed between a large diameter portion 68K and a large diameter portion 68M. Like the flow control member 66 in Fig. 53, a tapered portion 68V may be provided on the side of the first opening 66a of a large diameter portion 68W. Like the proximity sensor in Fig. 54, the step does not necessarily have to be provided in the internal flow path 66G of the flow control member 66.

In the embodiment, the proximity sensor is described as an example of the electronic device. However, the present invention is not limited to the proximity sensor. For example, the present invention may be applied to a photoelectric sensor, a fiber sensor, and a smart sensor.

The photoelectric sensor detects the presence or non-presence of the object or a change in surface state using various characters of the light emitted from the light emitting source. The detection unit of the photoelectric sensor includes a light emitting diode or a semiconductor laser, which is of the light emitting source. The fiber sensor is one in which an optical fiber is combined with the photoelectric sensor. The detection unit of the fiber sensor also includes the light emitting diode or the semiconductor laser, which is of the light emitting source. The smart sensor is one in which an analysis capacity or an information processing capacity is added to the proximity sensor or the photoelectric sensor. The detection unit of the smart sensor corresponds to the detection coil unit of the embodiment when the proximity sensor is used as the basic configuration, and the detection unit of the smart sensor includes the light emitting diode or the semiconductor laser, which is of the light emitting source, when the photoelectric sensor is used as the basic configuration.

Although the embodiment and Examples of the present invention are described above, the disclosed embodiment and Examples are not restrictive but illustrative only. The technical scope of the present invention is indicated by the claims, and the meanings equivalent to the claims and all the changes within the claims are also included in the present invention.

The present invention can be applied to the electronic device including the detection unit that detects the approach or presence of the detection target.

## Claims

1. An electronic device comprising:
a case member comprising a base part (60) accommodating electronic components, the base part (60) having a tubular shape including a first end portion (310a), the first end portion comprising a clamp (80) inserted therein, and a second end portion (310b), the second end portion (310b) being closed by a cover portion (20); a flow control member (66) that has a tubular shape defining a internal space (66g), the flow control member (66) comprising a first opening (66a) at one end and a second opening (66b) at the other end, the flow control member (66) being disposed in the base part (60) such that the first opening (66a) is located on the side of the first end portion (310a) and such that the second opening (66b) is located on the side of the second end portion (310b); a gate (81) formed in the clamp and adapted for the injection of resin into the case member therethrough; and
a sealing resin (120) substantially filling the internal space of the base part of the case member;
**characterized in that** the sealing resin comprises an air bubble confined within the internal space (66g) of the flow control member (66); whereby the case member comprises a first resin flow path between the gate (81) and the internal space of the flow control member (66), the first flow path passing between the inner surface (310k) of the base part (60) and the outer surface (66n) of the flow control member (66) and through the second opening (66b) of the flow control member (66); and a second resin flow path (66G) between the gate (81) and the internal space of the flow control member (66) through the first opening (66a) of the flow control member (66);
wherein the air bubble is confined within the flow control member (66) where the resin following the first flow path and the resin following the second flow path join together; and
cross sectional shapes of the first flow path and the second flow path (66G) in a cross sectional surface perpendicular to a direction in which the tubular shape of the base part (60) extends are determined such that the resin flowing in the first flow path reaches the second opening (66b) earlier than the resin flowing in the second flow path (66G).

2. The electronic device according to claim 1, wherein the area of the second opening (66b) is larger than the area of the first opening (66a).

3. The electronic device according to claim 1 or 2, wherein the flow control member (66) is disposed coaxially with the center axis of the tubular base part (60).

4. The electronic device according to any of claims 1 to 3, wherein the cross sectional shape of the outer surface (66n) of the flow control member (66) has a circle shape corresponding to the shape of the inner surface (310k) of the tubular base part (60).

5. The electronic device according to any one of claims 1 to 4, wherein the sealing resin (120) comprises a thermoplastic resin having a shore D hardness of 60 or less.

6. The electronic device according to any one of claims 1 to 5, wherein the flow control member (66) comprises no opening except the first opening (66a) and the second opening (66b).

## Patentansprüche

1. Elektrische Vorrichtung, umfassend:
ein Gehäuse umfassend einen Grundkörper (60) zum Aufnehmen elektrischer Bauteile, wobei der Grundkörper (60) eine rohrförmige Form aufweist mit einem ersten Endabschnitt (310a), wobei der erste Endabschnitt (310a) eine darin eingesetzte Klammer (80) umfasst, und mit einem zweiten Endabschnitt (310b), wobei der zweite Endabschnitt (310b) mittels eines Abdeckungsabschnitts (20) verschlossen ist;
einen Fließregulierabschnitt (66) mit einer rohrförmigen Form, welcher einen Innenraum (66g) abgrenzt, wobei der Fließregulierabschnitt (66) eine erste Öffnung (66a) an einem Ende und eine zweite Öffnung (66b) an einem anderen Ende aufweist, wobei der Fließregulierabschnitt (66) derart in dem Grundkörper (60) angeordnet ist, dass sich die erste Öffnung (66a) auf der Seite des ersten Endabschnitts (310a) befindet und sich die zweite Öffnung (66b) auf der Seite des zweiten Endabschnitts (310b) befindet; eine Öffnung (81), die in der Klammer (80) ausgebildet ist und durch welche Harz in das Gehäuse einspritzbar ist; und
ein Dichtharz (120), das einen Innenraum des Grundkörpers (60) des Gehäuses im Wesentlichen ausfüllt;
**dadurch gekennzeichnet, dass** das Dichtharz (120) eine Luftblase umfasst, die in dem Innenraum (66g) des Fließregulierabschnitts (66) eingeschlossen ist;
wobei der Grundkörper (60) aufweist:
einen ersten Harz-Fließpfad zwischen der Öffnung (81) und dem Innenraum (66g) des Fließregulierabschnitts (66), wobei der erste Fließpfad zwischen einer inneren Oberfläche (310k) des Grundkörpers (60) und einer äußeren Oberfläche (66n) des Fließregulierabschnitts (66) und durch die zweite Öffnung (66b) des Fließregulierabschnitts (66) verläuft; und einen zweiten Harz-Fließpfad (66G) zwischen der Öffnung (81) und dem Innenraum des Fließregulierabschnitts (66) durch die erste Öffnung (66a) des Fließregulierabschnitts (66);
wobei die Luftblase in dem Fließregulierabschnitt (66) dort eingeschlossen ist, wo das Harz entlang dem ersten Fließpfad und das Harz entlang dem zweiten Fließpfad (66G) sich vereinigen; und
ein Querschnitt des ersten Fließpfades und ein Querschnitt des zweiten Fließpfades (66G) in einer Querschnittsfläche, welche senkrecht auf einer Richtung steht, in welche sich die rohrförmige Form des Grundkörpers (60) erstreckt, derart festgelegt sind, dass das Harz, welches entlang dem ersten Fließpfad fließt, die zweite Öffnung (66b) vor dem Harz erreicht, welches entlang dem zweiten Fließpfad (66G) fließt.

2. Elektrische Vorrichtung nach Anspruch 1, wobei eine Fläche der zweiten Öffnung (66b) größer ist als eine Fläche der ersten Öffnung (66a).

3. Elektrische Vorrichtung nach Anspruch 1 oder 2, wobei der Fließregulierabschnitt (66b) koaxial zu einer mittleren Achse des rohförmigen Grundkörpers (60) angeordnet ist.

4. Elektrische Vorrichtung nach einem der Ansprüche 1 bis 3, wobei ein Querschnitt der äußeren Oberfläche (66n) des Fließregulierabschnitts (66) eine kreisförmige Form aufweist, die der Form der inneren Oberfläche (310k) des rohrförmigen Grundkörpers (60) entspricht.

5. Elektrische Vorrichtung nach einem der Ansprüche 1 bis 4, wobei das Dichtharz (120) ein thermoplastisches Harz mit einer Shore-D-Härte von 60 oder weniger umfasst.

6. Elektrische Vorrichtung nach einem der Ansprüche 1 bis 5, wobei der Fließregulierabschnitt (66) außer der ersten Öffnung (66a) und der zweiten Öffnung (66b) keine Öffnung aufweist.

## Revendications

1. Dispositif électronique comprenant :
un élément de boîtier comprenant une partie de base (60) logeant des composants électroniques, la partie de base (60) ayant une forme tubulaire comprenant une première partie d'extrémité (310a), la première partie d'extrémité comprenant une bride (80) insérée dans celle-ci, et une seconde partie d'extrémité (310b), la seconde partie d'extrémité (310b) étant fermée par une partie de couvercle (20) ;
un élément de régulation de débit (66) qui a une forme tubulaire définissant un espace interne (66g), l'élément de régulation de débit (66) comprenant une première ouverture (66a) à une extrémité et une seconde ouverture (66b) à l'autre extrémité, l'élément de régulation de débit (66) étant disposé dans la partie de base (60) de sorte que la première ouverture (66a) est située du côté de la première partie d'extrémité (310a) et de sorte que la seconde ouverture (66b) est située du côté de la seconde partie d'extrémité (310b) ;
une porte (81) formée dans la bride et conçue pour l'injection de résine dans l'élément de boîtier à travers celle-ci ; et
une résine d'étanchéité (120) remplissant sensiblement l'espace interne de la partie de base de l'élément de boîtier ; **caractérisé en ce que** la résine d'étanchéité comprend une bulle d'air confinée dans l'espace interne (66g) de l'élément de régulation de débit (66) ; moyennant quoi l'élément de boîtier comprend un premier chemin d'écoulement de résine entre la porte (81) et l'espace interne de l'élément de régulation de débit (66), le premier chemin d'écoulement passant entre la surface intérieure (310k) de la partie de base (60) et la surface extérieure (66n) de l'élément de régulation de débit (66) et à travers la seconde ouverture (66b) de l'élément de régulation de débit (66) ; et un second chemin d'écoulement de résine (66G) entre la porte (81) et l'espace interne de l'élément de régulation de débit (66) à travers la première ouverture (66a) de l'élément de régulation de débit (66) ;
dans lequel la bulle d'air est confinée à l'intérieur de l'élément de régulation de débit (66) où la résine suivant le premier chemin d'écoulement et la résine suivant le second chemin d'écoulement se rejoignent ; et
des formes en coupe transversale du premier chemin d'écoulement et du second chemin d'écoulement (66G) dans une surface en coupe transversale perpendiculaire à une direction dans laquelle la forme tubulaire de la partie de base (60) s'étend sont déterminées de sorte que la résine circulant dans le premier chemin d'écoulement atteint la seconde ouverture (66b) plus tôt que la résine circulant dans le second chemin d'écoulement (66G).

2. Dispositif électronique selon la revendication 1, dans lequel l'aire de la seconde ouverture (66b) est plus grande que l'aire de la première ouverture (66a).

3. Dispositif électronique selon la revendication 1 ou 2, dans lequel l'élément de régulation de débit (66) est disposé coaxialement à l'axe central de la partie de base tubulaire (60).

4. Dispositif électronique selon l'une quelconque des revendications 1 à 3, dans lequel la forme en coupe transversale de la surface extérieure (66n) de l'élément de régulation de débit (66) a une forme de cercle correspondant à la forme de la surface intérieure (310k) de la partie de base tubulaire (60).

5. Dispositif électronique selon l'une quelconque des revendications 1 à 4, dans lequel la résine d'étanchéité (120) comprend une résine thermoplastique ayant une dureté Shore D de 60 ou moins.

6. Dispositif électronique selon l'une quelconque des revendications 1 à 5, dans lequel l'élément de régulation de débit (66) ne comporte aucune ouverture à l'exception de la première ouverture (66a) et de la seconde ouverture (66b).
